# EUROPEAN PATENT SPECIFICATION

(11) **EP 1 411 634 B1**
(45) Date of publication and mention of the grant of the patent: **28.01.2009**
(21) Application number: 02741345.9
(22) Date of filing: 26.06.2002
(51) Int. Cl.: H03H 9/145

(54) **SURFACE ACOUSTIC WAVE FILTER**
OBERFLÄCHENWELLENFILTER
FILTRE A ONDE ACOUSTIQUE DE SURFACE

(30) Priority: 29.06.2001 JP 2001198192
(43) Date of publication of application: 21.04.2004
(73) Proprietor: Panasonic Corporation, Kadoma-shi Osaka 571-8501 (JP)
(72) Inventor: TSUNEKAWA, Akio, Moriguchi-shi, Osaka 570-0014 (JP); SEKI, Shunichi, Amagasaki-shi, Hyogo 661-0982 (JP); NAKAYA, Shinobu, Neyagawa-shi, Osaka 572-0055 (JP); NAKAMURA, Hiroyuki, Katano-shi, Osaka 576-0016 (JP); YAMADA, Toru, Katano-shi, Osaka 576-0033 (JP)
(74) Representative: Grünecker, Kinkeldey, Stockmair & Schwanhäusser Anwaltssozietät
(86) International application number: PCT/JP2002/006434
(87) International publication number: WO 2003/003574

(56) References cited:
- WO-A1-00/69069
- JP-A- 8 250 969
- JP-A- 2002 009 587
- JP-A- 2002 009 588
- JP-A- 2002 204 139
- US-A- 5 835 990

## Description

The present invention relates to longitudinally coupled surface acoustic wave filters each delivering low-loss performance.

### BACKGROUND ART

To obtain a desired frequency response, a surface acoustic wave filter is widely used among mobile communication apparatuses. The surface acoustic wave filters used in the RF stage, in particular, include a ladder filter having resonators connected in a ladder configuration and a longitudinal mode filter utilizing a mode through acoustic coupling. Since loss of the filter in the RF stage directly affects sensitivity of the mobile communication apparatus, low-loss performance is demanded of the filter. Moreover, semiconductor device such as an IC has become adopting balanced input/output in recent years for noise reduction, thus requiring the surface acoustic wave filter used in the RF stage to be balanced accordingly.

A description is hereinafter provided of a conventional longitudinally coupled surface acoustic wave filter having a balanced input/output port.

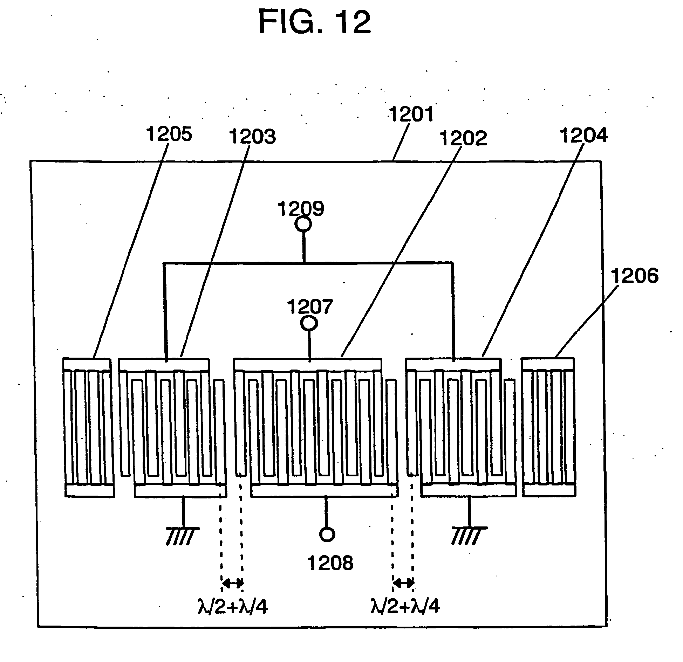

Fig. 12 illustrates the conventional longitudinal mode surface acoustic wave filter.

In Fig. 12, the surface acoustic wave filter includes first, second and third interdigital transducer electrodes (hereinafter referred to as IDT electrodes) 1202, 1203, 1204 and first and second reflector electrodes 1205, 1206 on piezoelectric substrate 1201.

First IDT electrode 1202 has upper electrode fingers coupled to first terminal 1207 of the balanced port, and lower electrode fingers coupled to second terminal 1208 of the balanced port.

Second and third IDT electrodes 1203, 1204 each have, on the same side, electrode fingers coupled to unbalanced port 1209, and electrode fingers on the other side of these IDT electrodes 1203, 1204 are grounded. By having the structure described above, the surface acoustic wave filter obtained has the unbalanced and balanced ports.

In the above-described surface acoustic wave filter, a difference between resonance frequencies of primary and tertiary modes is used for securing a pass bandwidth for the filter. To obtain broadband characteristics, it is known that a spacing between first IDT electrode 1202 and each of second and third IDT electrodes 1203, 1204 is deviated substantially by λ/4 from a periodic structure. Fig. 12 illustrates the structure in which the spacing is deviated by +λ/4.

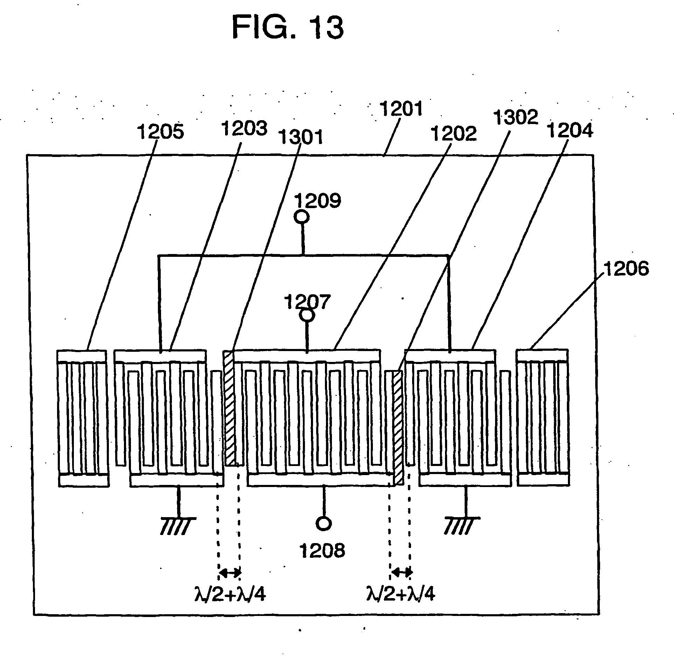

With this structure, however, piezoelectric substrate 1201 has a large free surface portion between the IDT electrodes due to the increased spacing between first IDT electrode 1202 and each of second and third IDT electrodes 1203, 1204, thereby causing propagation loss which results in increased filter loss. Known measures taken against this problem include a structure such as shown in Fig. 13 in which the area of the free surface portion of piezoelectric substrate 1201 is reduced by means of metal electrodes 1301, 1302 or the like.

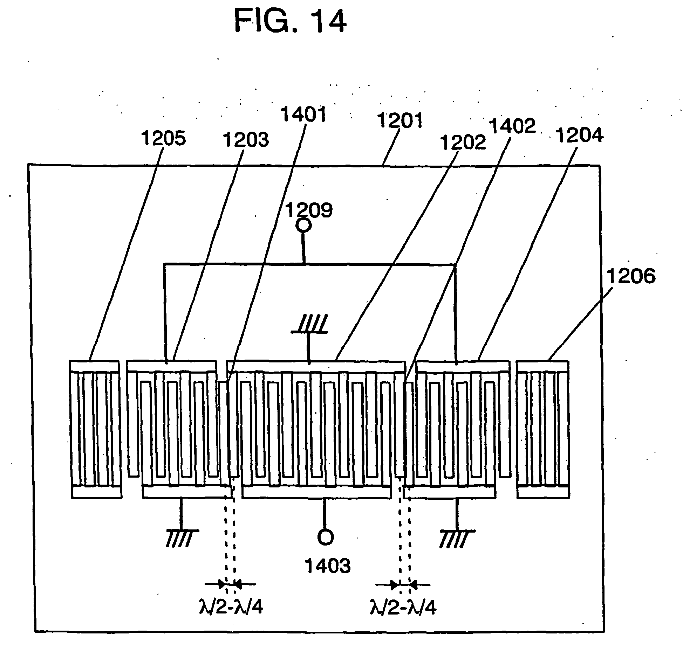

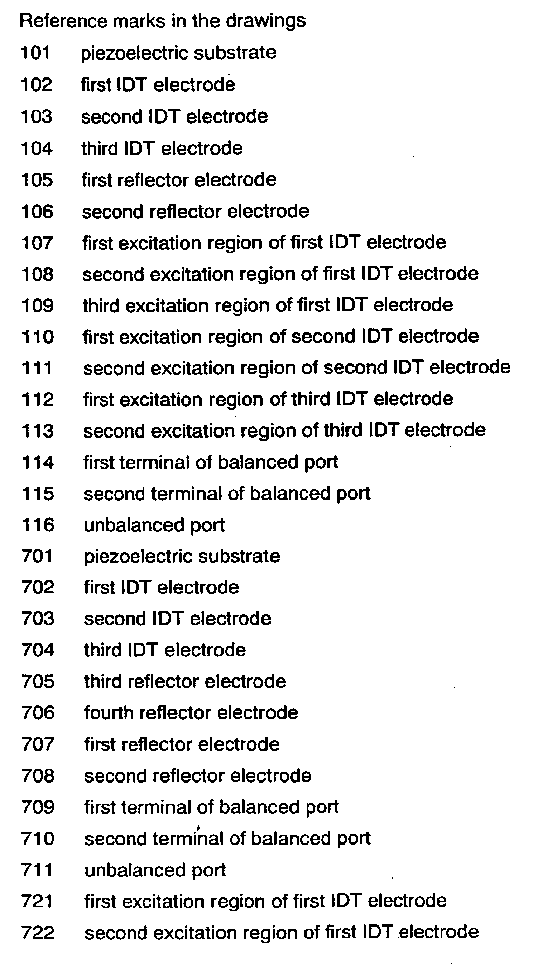

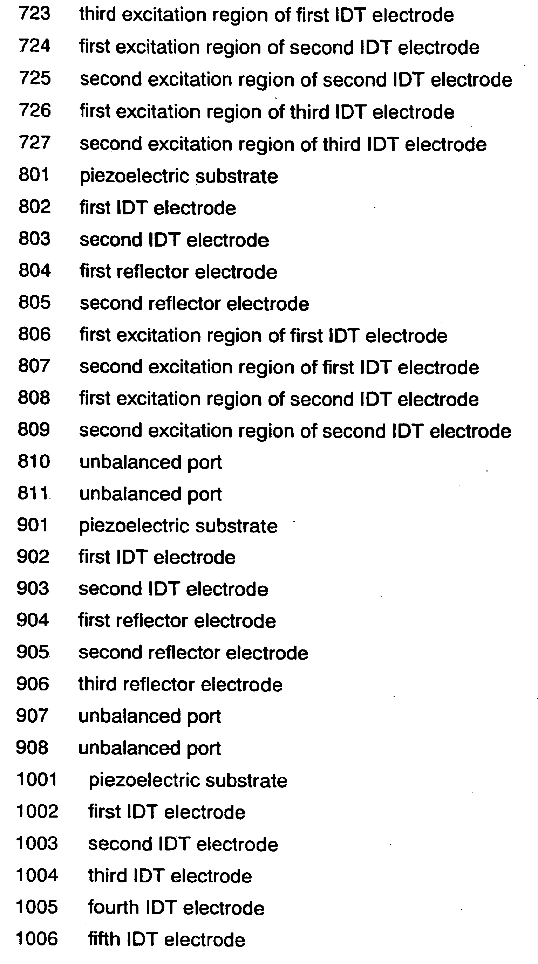

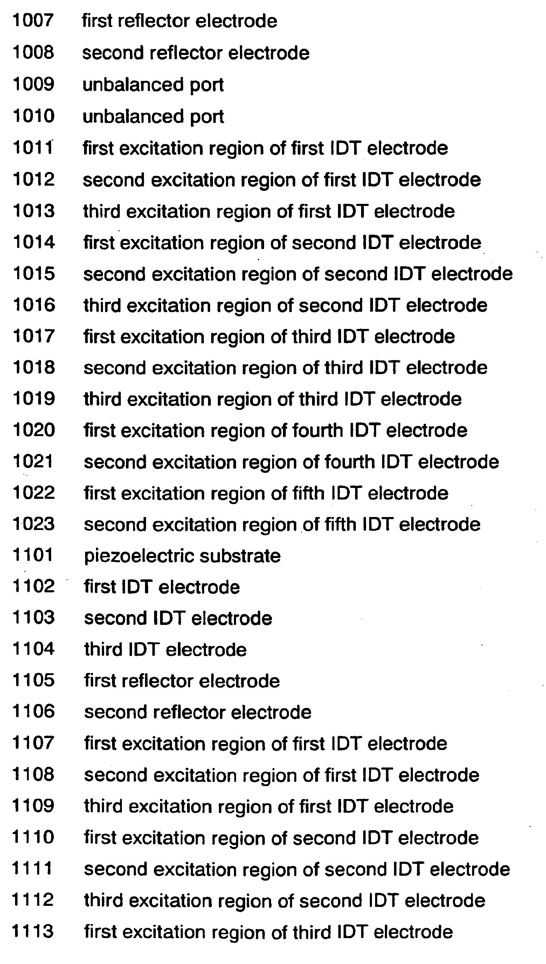

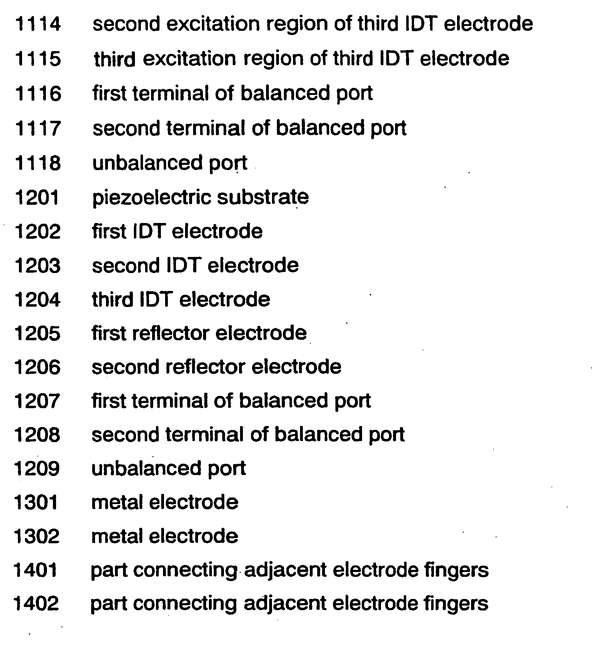

Japanese Patent Unexamined Publication No. H05-267990 discloses a structure having a λ/4 spacing between centers of the respective adjacent electrode fingers of first and second IDT electrodes 1202, 1203. In other words, this structure has a deviating amount of -λ/4 and as shown in Fig. 14, includes part 1401 connecting the respective adjacent electrode fingers of first and second IDT electrodes 1202, 1203 and part 1402 connecting the respective adjacent electrode fingers of first and third IDT electrodes 1202, 1204. In this structure, the upper electrode fingers of first IDT electrode 1202 are grounded, while the lower electrode fingers thereof are coupled to unbalanced port 1403, so that this surface acoustic wave filter has the ports both unbalanced. However, the balanced port such as shown in Fig. 12 cannot be implemented because the second and third IDT electrodes are connected with the first IDT electrode by parts 1401, 1402, respectively.

In each of the above cases, the ratio of the spacing between the IDT electrodes to an electrode finger pitch of the IDT electrode is 1.5 or 0.5, and the periodic structure is discontinuous. Consequently, filter characteristics degrades due to, for example, bulk radiation of a surface acoustic wave.

In the longitudinal coupling dual mode SAW filter disclosed in document JP 8 250 969 A an input IDT, two output IDTs, two gratings and two reflectors are arranged on the surface of a piezoelectric substrate along the propagation direction of the surface acoustic wave. The output IDTs and gratings are provided to both sides of the input IDT, wherein each grating comprises n fingers arranged at an equal interval and is interposed between the input IDT and one output IDT. The reflectors are provided to both sides of the assembly consisting of input IDT, output IDTs and gratings on the piezoelectric substrate.

It is an object of the present invention to provide for a longitudinally coupled surface acoustic wave filter having low-loss filter characteristics.

This is achieved by the features as set forth in claim 1. Further advantageous embodiments of the present invention are set forth in the dependent claims.

A surface acoustic wave filter includes a piezoelectric substrate, and a plurality of interdigital transducer electrodes (IDT electrodes) and a plurality of reflector electrodes disposed on the piezoelectric substrate. Each of the IDT electrodes is an interdigital electrode including a plurality of opposed electrode fingers, and each of the reflector electrodes is formed of an arrangement of a plurality of electrode fingers. The IDT electrodes and the reflector electrodes are arranged in close relation along a propagation direction of a surface acoustic wave. The IDT electrode includes a primary excitation region having λ/2 electrode finger pitches, where λ is a wavelength of the surface acoustic wave. The primary excitation region of at least one of the IDT electrodes is phase-shifted from the primary excitation region of another IDT electrode by a certain amount in accordance with a desired passband frequency response. The IDT electrode includes at least one secondary excitation region having electrode finger pitches different from the λ/2 pitches, and/or at least one of the reflector electrodes includes electrode finger pitches different from the λ/2 pitches. The surface acoustic wave filter thus has a propagation path having reduced discontinuity and hence low-loss filter characteristics.

### BRIEF DESCRIPTION OF THE DRAWINGS

Fig. 1 illustrates a surface acoustic wave filter in accordance with a first exemplary embodiment of the present invention.
Fig. 2A is an enlarged view illustrating electrode fingers arranged at equal pitches in secondary excitation regions when the deviating amount is -λ/4, and Fig. 2B is an enlarged view illustrating electrode fingers arranged at pitches varying stepwise in secondary excitation regions when the deviating amount is -λ/4.
Fig. 3A is an enlarged view illustrating electrode fingers arranged at equal pitches in secondary excitation regions when the deviating amount is +λ/4, and Fig. 3B is an enlarged view illustrating electrode fingers arranged at pitches varying stepwise in secondary excitation regions when the deviating amount is +λ/4.
Fig. 4 illustrates a filter in accordance with the first embodiment of the present invention.
Fig. 5A shows filter characteristics when n1=n2=3, Fig. 5B shows filter characteristics when n1=n2=5, and Fig. 5C shows filter characteristics when n1=n2=7.
Fig. 6 shows measured characteristics of a filter when n1=n2=5 and measured characteristics of a conventional filter.
Fig. 7A illustrates a surface acoustic wave filter in accordance with a second exemplary embodiment, and Fig. 7B illustrates another surface acoustic wave filter in accordance with the second embodiment.
Fig. 8 illustrates a surface acoustic wave filter in accordance with a third exemplary embodiment of the present invention.
Fig. 9 illustrates a surface acoustic wave filter in accordance with a fourth exemplary embodiment.
Fig. 10 illustrates a surface acoustic wave filter in accordance with a fifth exemplary embodiment of the present invention.
Fig. 11 illustrates a surface acoustic wave filter in accordance with a sixth exemplary embodiment of the present invention.
Fig. 12 illustrates a conventional surface acoustic wave filter.
Fig. 13 illustrates another conventional surface acoustic wave filter.
Fig. 14 illustrates still another conventional surface acoustic wave filter.

### FIRST EXEMPLARY EMBODIMENT

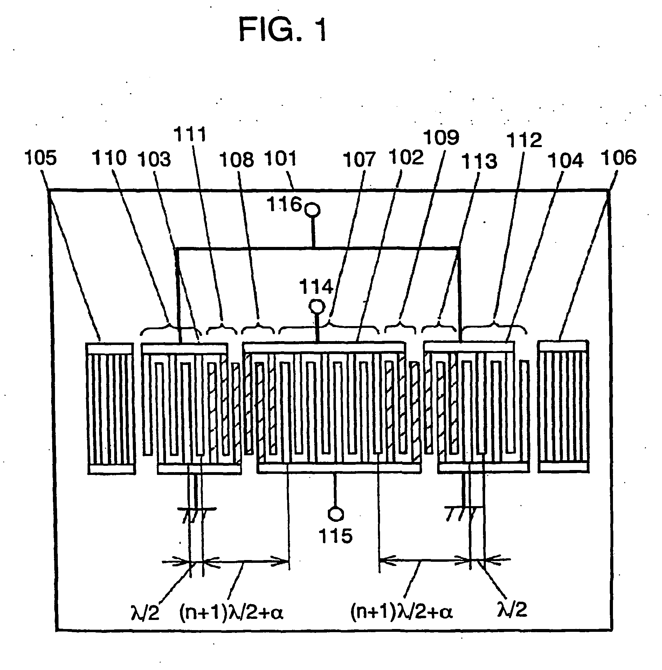

Fig. 1 schematically illustrates a surface acoustic wave filter in accordance with the first exemplary embodiment.

In Fig. 1, a pattern of interdigital electrodes each including opposed electrode fingers is formed on piezoelectric substrate 101, whereby a surface acoustic wave can be excited. The surface acoustic wave filter formed is a longitudinally coupled type including first, second and third IDT electrodes 102, 103, 104 and first and second reflector electrodes 105, 106 on piezoelectric substrate 101.

In the surface acoustic wave filter mentioned above, the upper electrode fingers of first IDT electrode 102 are coupled to first terminal 114 of a balanced port, while the lower electrode fingers of this IDT electrode 102 are coupled to second terminal 115 of the balanced port. The upper electrode fingers of second IDT electrode 103 are coupled to unbalanced port 116, while the lower electrode fingers thereof are grounded. Similarly, the upper electrode fingers of third IDT electrode 104 are coupled to unbalanced port 116, while the lower electrode fingers thereof are grounded. This surface acoustic wave filter thus includes the unbalanced and balanced ports.

First IDT electrode 102 is divided into three regions including first excitation region 107, second excitation region 108 and third excitation region 109.

In first IDT electrode 102, first excitation region 107 is located between second and third excitation regions 108, 109. Second IDT electrode 103 is divided into two regions including first excitation region 110 and second excitation region 111.

Second excitation region 111 of second IDT electrode 103 is located adjacent to first IDT electrode 102. Third IDT electrode 104 is divided into two regions including first excitation region 112 and second excitation region 113. Second excitation region 113 of third IDT electrode 104 is located adjacent to first IDT electrode 102.

First excitation regions 107, 110, 112 of first, second and third IDT electrodes 102, 103, 104 are referred to as primary excitation regions. Throughout these primary excitation regions, a spacing (hereinafter referred to as an electrode finger pitch) between respective centers of the adjacent electrode fingers is set at λ/2, where λ is the wavelength of the surface acoustic wave to be excited. The second and third excitation regions in first, second and third IDT electrodes 102, 103, 104 are referred to as secondary excitation regions.

A spacing between an excitation center of first excitation region 107 of first IDT electrode 102 and an excitation center of first excitation region 110 of second IDT electrode 103 is deviated by amount α from the λ/2 periodic structure. Similarly, a spacing between the excitation center of first excitation region 107 of first IDT electrode 102 and an excitation center of first excitation region 112 of third IDT electrode 104 is deviated by amount α from the λ/2 periodic structure. In other words, the periodic arrangement of the electrode fingers in primary excitation region 110 of second IDT electrode 103 is phase-shifted by α from the periodic arrangement of the electrode fingers in primary excitation region 107 of first IDT electrode 102. Similarly, the periodic arrangement of the electrode fingers in primary excitation region 112 of third IDT electrode 103 is phase-shifted by α from the periodic arrangement of the electrode fingers in primary excitation region 107 of first IDT electrode 102.

Second and third excitation regions 108, 109 of first IDT electrode 102, second excitation region 111 of second IDT electrode 103 and second excitation region 113 of third IDT electrode 104 each have electrode finger pitches different from the λ/2 pitches. With the structure described above, the IDT electrode converts an electric signal, input from the unbalanced or balanced port, to the surface acoustic wave, which is confined between the reflector electrodes, so that a standing wave is generated on the piezoelectric substrate, and consequently, a plurality of resonance modes is formed. Value α is optimized so as to couple the primary and tertiary resonance modes together, whereby desired filter characteristics is obtained.

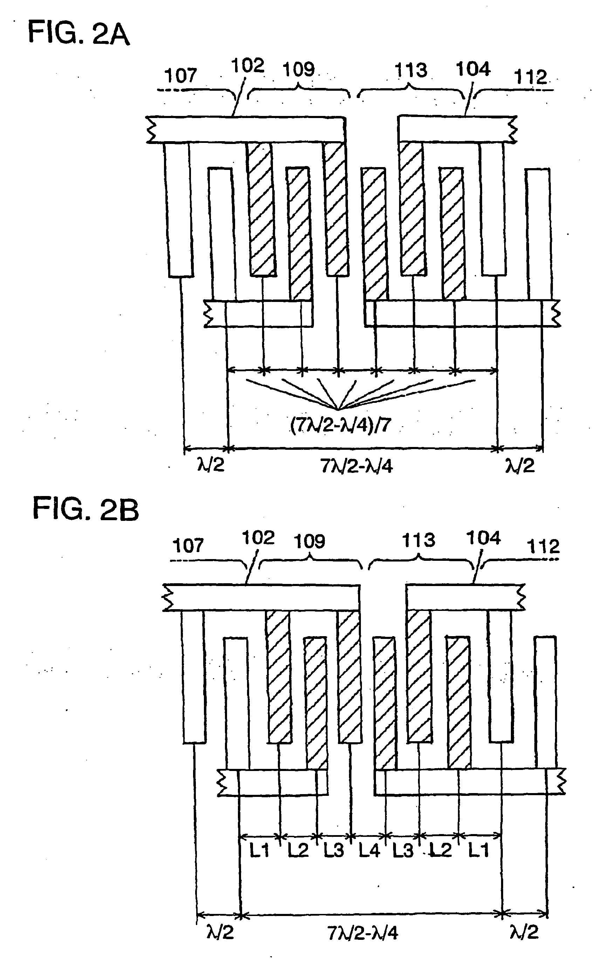

Referring to the accompanying drawings, a description is provided next of respective adjacent portions of first and third IDT electrodes 102, 104. Fig. 2 includes enlarged views each illustrating the respective adjacent portions of first and third IDT electrodes 102, 104 when deviating amount α=-λ/4. In each of these cases, third excitation region 109 of first IDT electrode 102 and second excitation region 113 of third IDT electrode 104 each have three electrode fingers.

In each of these cases, the distance between centers of the respective fingers nearest to each other in first excitation regions 107, 112 of the first and third IDT electrodes is 7λ/2-λ/4.

Fig. 2A illustrates the electrode fingers arranged at equal pitches in excitation regions 109, 113 of first and third IDT electrodes 102, 104.

Since there are seven finger-to-finger spacings for the six electrode fingers, every electrode finger pitch is (7λ/2-λ/4)/7. Therefore, the ratio of the electrode finger pitch of first excitation region 107 to the electrode finger pitch of third excitation region 109 of first IDT electrode 102 as well as the ratio of the electrode finger pitch of first excitation region 112 to the electrode finger pitch of second excitation region 113 of third IDT electrode 104 is 0.929. Accordingly , the difference between the respective electrode finger pitches of first and third excitation regions 107, 109 as well as between the respective electrode finger pitches of first and second excitation regions 112, 113 is about 7%. Thus, a resulting structure has reduced discontinuity. The application of the same structure to the respective adjacent portions of first and second IDT electrodes 102, 103 allows the surface acoustic wave filter to have as a whole a substantially periodic structure having reduced discontinuity along a propagation direction.

Fig. 2B illustrates the electrode fingers arranged at pitches varying stepwise in excitation regions 109, 113 of first and third IDT electrodes 102, 104.

In this case, the discontinuity can be reduced by optimizing electrode finger pitches L1, L2, L3, L4. For example, setting λ/2>L1>L2>L3>L4 can reduce the discontinuity between the adjacent fingers.

If L1=L2=L3=L4 in Fig. 2B, this is similar to the structure illustrated by Fig. 2A.

If L1=L2 ≠ L3=L4 in Fig. 2B, excitation regions 109, 113 include two different kinds of electrode finger pitches. Even in this case, the discontinuity can be less than that of a conventional case, whereby bulk radiation loss can be reduced, and the filter can have reduced loss as a whole.

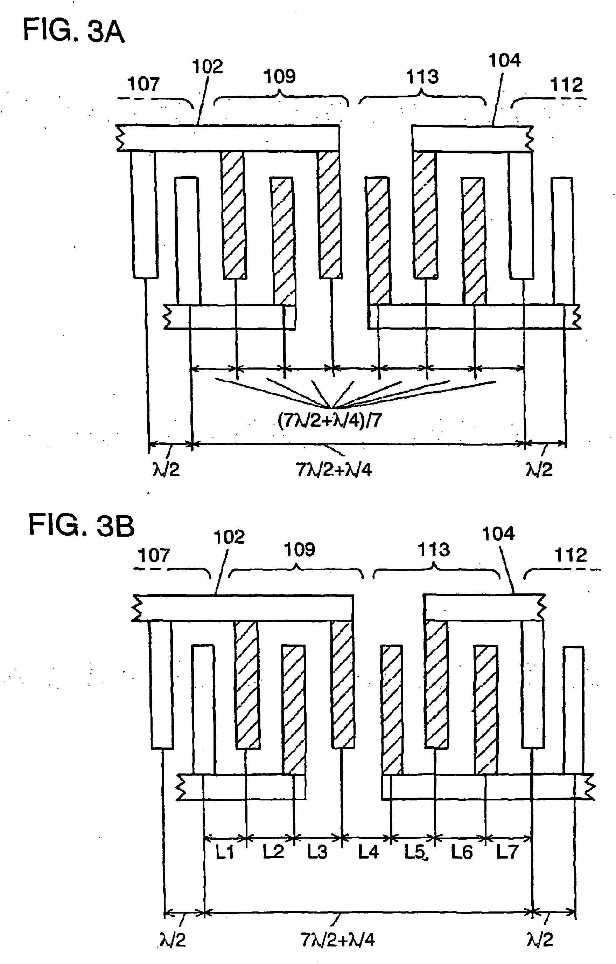

A description is provided next of cases where deviating amount α=+λ/4. Fig. 3 includes enlarged views each illustrating the respective adjacent portions of first and third IDT electrodes 102, 104 when +λ/4. In each of these cases, third excitation region 109 of first IDT electrode 102 and second excitation region 113 of third IDT electrode 104 each have three electrode fingers, and the distance between centers of the respective fingers nearest to each other in first excitation regions 107, 112 of the first and third IDT electrodes is 7λ/2+λ/4.

Fig. 3A illustrates the electrode fingers arranged at equal pitches in excitation regions 109, 113 of the first and third IDT electrodes102, 104.

Since there are seven finger-to-finger spacings for the six electrode fingers, every electrode finger pitch is (7λ/2+λ/4)/7. Therefore, the ratio of the electrode finger pitch of first excitation region 107 to the electrode finger pitch of third excitation region 109 of first IDT electrode 102 as well as the ratio of the electrode finger pitch of first excitation region 112 to the electrode finger pitch of second excitation region 113 of third IDT electrode 104 is 1.071. Accordingly , the difference between the respective electrode finger pitches of first and third excitation regions 107, 109 as well as between the respective electrode finger pitches of first and second excitation regions 112, 113 is about 7%. Thus, a resulting structure has reduced discontinuity.

The application of the same structure to the respective adjacent portions of first and second IDT electrodes 102, 103 allows the surface acoustic wave filter to have as a whole a substantially periodic structure having reduced discontinuity along the propagation direction.

Fig. 3B illustrates the electrode fingers arranged at pitches varying stepwise in excitation regions 109, 113 of first and third IDT electrodes 102, 104. In the case of Fig. 3B, the discontinuity can be reduced by optimizing electrode finger pitches L1, L2, L3, L4. For example, setting λ/2<L1<L2<L3<LA can reduce the discontinuity between the adjacent fingers.

If L1=L2=L3=L4 in Fig. 3B, this is similar to the structure illustrated by Fig. 3A.

If L1=L2 ≠ L3=L4 in Fig. 3B, excitation regions 109, 113 include two different kinds of electrode finger pitches. Even in this case, the discontinuity can be less than that of the conventional case, whereby the bulk radiation loss can be reduced. Consequently, the filter can have reduced loss as a whole.

Next, a description is provided of cases where second and third excitation regions 108, 109 of first IDT electrode 102 each have n1 electrode fingers, while respective second excitation regions 111, 113 of second and third IDT electrodes 103, 104 each have n2 electrode fingers. It is to be noted here that first IDT electrode 102 has a total of N1 electrode fingers, while second and third IDT electrodes 103, 104 each have a total of N2 electrode fingers.

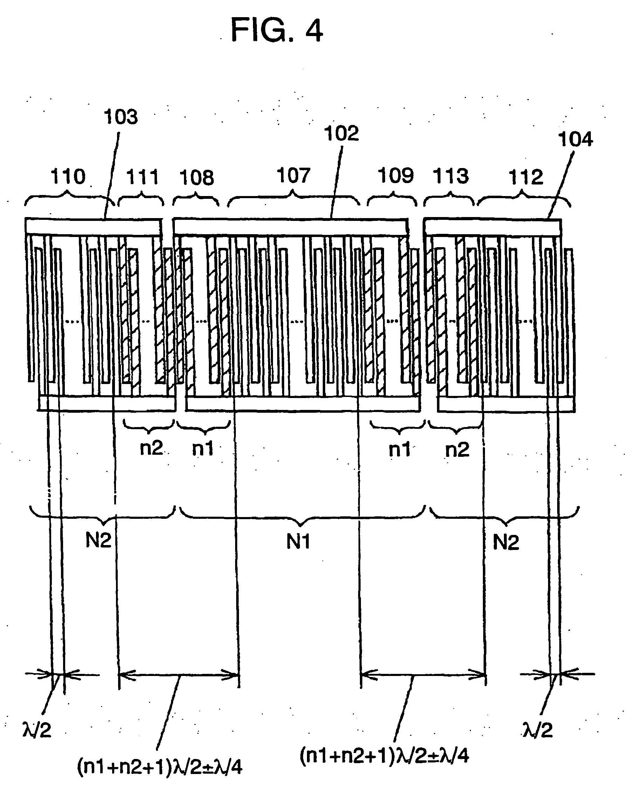

As shown in Fig. 4, the distance between centers of the respective fingers nearest to each other in first excitation regions 107, 110 of first and second IDT electrodes 102, 103 as well as between centers of the respective fingers nearest to each other in first excitation regions 107, 112 of first and third IDT electrodes 102, 104 is (n1+n2+1)λ/2±λ/4. It is to be noted here that deviating amount α is equal to +λ/4 when there is "+" in front of λ/4 and -λ/4 when there is "-" in front of λ/4.

When the electrode fingers are arranged at equal pitches in excitation regions 108, 111 of first and second IDT electrodes 102, 103 as well as in excitation regions 109, 113 of first and third IDT electrodes 102, 104, there exist (n1+n2+1) finger-to-finger spacings in excitation regions 108, 111 as well as in excitation regions 109, 113, so that every electrode finger pitch is {(n1+n2+1)λ/2+λ/4}/(n1+n2+1). Therefore, the ratio of the electrode finger pitch of each of first excitation regions 107, 110, 112 of IDT electrodes 102, 103, 104 to the electrode finger pitch of each of excitation regions 108, 111, 109, 113 is 1±1/{2(n1+n2+1)}.

With this structure, the discontinuity can be minimized, by appropriately selecting n1 and n2. The selection of n1 and n2 is determined by a trade-off between the discontinuity and the filter characteristics. In other words, the increase in n1 and n2 results in reduced discontinuity, but results in an unsatisfactory filter not having a desired passband frequency response because the number of electrode fingers, which determines a main part of the filter characteristics, in the first excitation region of each of the IDT electrodes decreases accordingly. Conversely, the decrease in n1 and n2 results in a filter having increased discontinuity and increased loss caused by bulk radiation or the like.

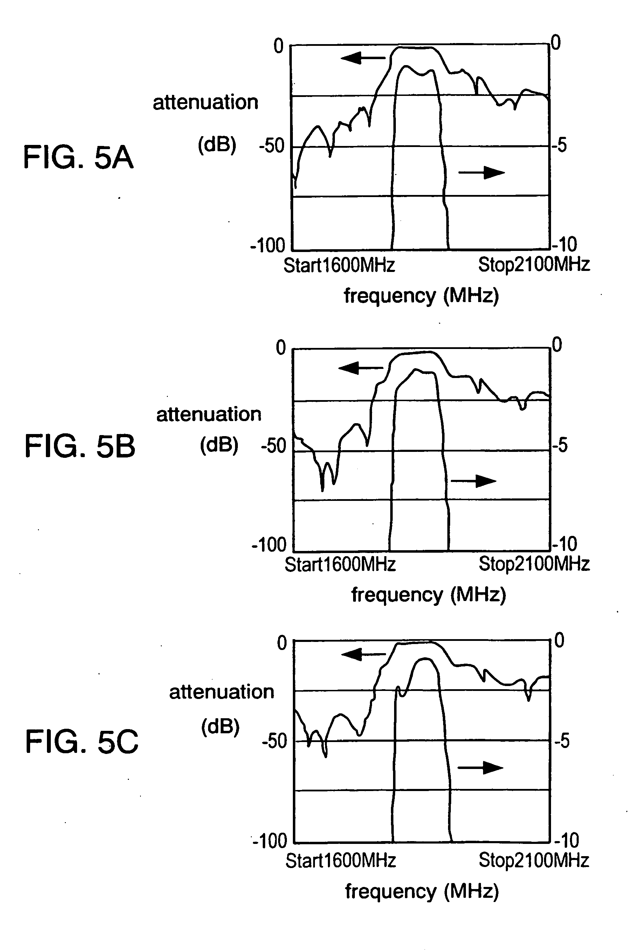

Figs. 5A-5C illustrate filter characteristics when n1 and n2 are varied. In each of these graphs, the vertical axis shows passing characteristics (attenuation characteristics) on two different scales.

Specifically, Fig. 5A illustrates the passing characteristics when n1=n2=3, Fig. 5B illustrates the passing characteristics when n1=n2=5, and Fig. 5C illustrates the passing characteristics when n1=n2=7. As can be seen from these drawings, as n1 and n2 increase, the attenuation increases accordingly. This is because the number of electrode fingers in each of first excitation regions 107, 110, 112 becomes smaller with respect to the number of electrode fingers in the secondary excitation region(s). In this case, the first IDT electrode has a total of 31 electrode fingers, and the second and third IDT electrodes each have a total of 19 electrode fingers.

Of the total number of electrode fingers of each of the second and third IDT electrodes, the number of electrode fingers in the second excitation region accounts for (n2)/N2=3/19=0.158 in the case of Fig. 5A, (n2)/N2=5/19=0.263 in the case of Fig. 5B, and (n2)/N2=7/19=0.368 in the case of Fig. 5C. Of the total number of electrode fingers of the first IDT electrode, the number of electrode fingers in the second and third excitation regions accounts for (n1+n1)/N1=(3+3)/31=0.194 in the case of Fig. 5A, (n1+n1)/N1=(5+5)/31=0.323 in the case of Fig. 5B, and (n1+n1)/N1=(7+7)/31=0.452 in the case of Fig. 5C.

As shown by Figs. 5A-5C, the attenuation increases to a large extent when n1=n2=7. It is thus preferable that the number of electrode fingers in the secondary excitation region(s) accounts for 1/3 or less (i.e. (n1+n1)/N1<1/3 or (n2)/N2<1/3) of the total number of fingers of the IDT electrode.

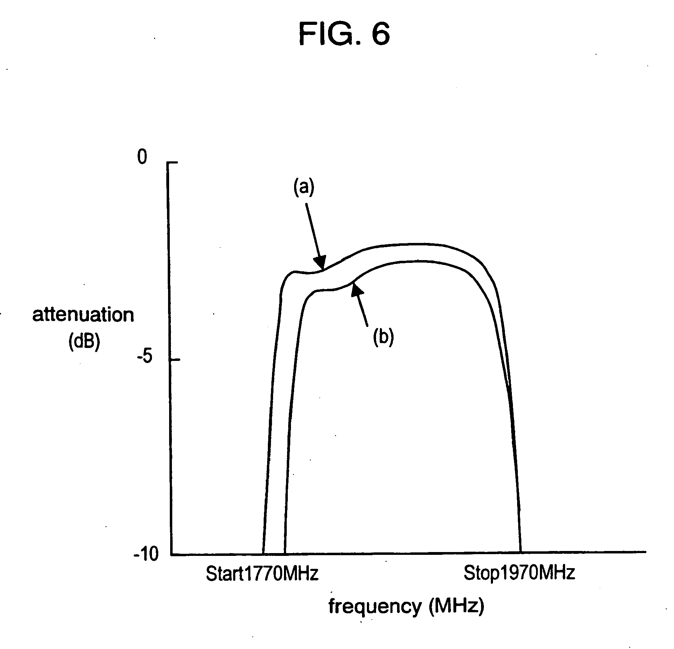

Fig. 6 shows measured characteristics (a) of a filter when n1=n2=5 and measured characteristics (b) of a conventional filter. As can be seen from Fig. 6, there is an improvement of 0.5 dB or more in loss.

As described above, deviating the first excitation regions of the first, second and third IDT electrodes by the certain amount affords the characteristics of the longitudinal mode surface acoustic wave filter using the primary and tertiary modes. Further, optimizing the electrode finger pitches of the secondary excitation regions of the first, second and third IDT electrodes reduces the discontinuity, so that all the electrode fingers form the substantially continuous periodic structure, thus reducing the loss caused by the bulk radiation resulting from discontinuity of acoustic impedance.

In the above description, the same number of electrode fingers is used in the secondary excitation region of each of the first, second and third IDT electrodes. However, the number of fingers in the secondary excitation region may be optimized according to the total number of fingers of each of the IDT electrodes. In other words, an optimum excitation condition can be obtained by making n1 differ from n2.

The first excitation region of the first IDT electrode is deviated by -λ/4 or +λ/4 from the respective first excitation regions of the second and third IDT electrodes. However, the deviating amount is not limited to these values. The deviating amount is one of parameters determining a passband of the filter and is therefore optimized in accordance with desired filter characteristics.

In the present embodiment, the surface acoustic wave filter is configured to have the unbalanced and balanced ports. In this structure, balancing characteristics of the balanced port becomes an essential parameter. The balancing characteristics can be improved by, for example, slightly increasing distance L4 between first IDT electrode 102 coupled to the balanced port and each of IDT electrodes 103, 104 coupled to the unbalanced port such that λ/2>L1=L2=L3<L4 in Fig. 2B. Although the increase in L4 results in the slight decrease in each of electrode finger pitches L1, L2, L3 in this case, the loss can be reduced as a result of reduced discontinuity, and the balancing characteristics can be improved as long as the ratio between the adjacent electrode finger pitches of the IDT electrode ranges from 0.8 to 1.2. An ideal balancing characteristics can be obtained when a signal input from unbalanced port 116 and output to first terminal 114 of the balanced port and a signal input from unbalanced port 116 and output to second terminal 115 of the balanced port are of the same amplitude and oppositely phased. The balancing characteristics practically deviates from an ideal value due to, for example, a parasitic component between the IDT electrodes. However, the balancing characteristics can be improved by changing the parasitic component between the IDT electrodes through adjustment of the electrode finger pitches.

The present embodiment has referred to the electrode finger pitch only. In addition to the electrode finger pitch, a metallization ratio (the ratio of an electrode finger width to the finger-to-finger spacing) can be changed, too. For example, since the electrode finger pitch of secondary excitation regions 109, 113 is smaller than the electrode finger pitch of primary excitation regions 107, 112 in Fig. 2A, setting the metallization ratio of secondary excitation regions 109, 113 larger than that of primary excitation regions 107, 112 can bring the electrode finger width of the secondary excitation regions close to the electrode finger width of the primary excitation regions. With the electrode finger pitch and the metallization ratio thus taken into account for reduced discontinuity, the loss can be reduced further.

As long as the electrode finger pitches of the surface acoustic wave filter are set to define the periodic structure of the present invention, the similar advantages can be obtained even when the input/output direction is reversed.

The present embodiment has referred to the balanced and unbalanced ports. However, the ports may both be unbalanced or balanced. The similar advantages can be obtained even when the input/output direction is reversed as long as the electrode finger pitches of the surface acoustic wave filter are set to define the periodic structure of the present invention.

The application of the present invention to a filter using a leaky surface acoustic wave can enhance the effect of reducing the bulk radiation loss. With the leaky surface acoustic wave, the proportion of the bulk radiation loss generally increases in wave mode conversion due to the presence of discontinuity, so that the filter is likely to have increased loss as a whole. However, the application of the present invention can reduce the bulk radiation loss.

### SECOND EXEMPLARY EMBODIMENT

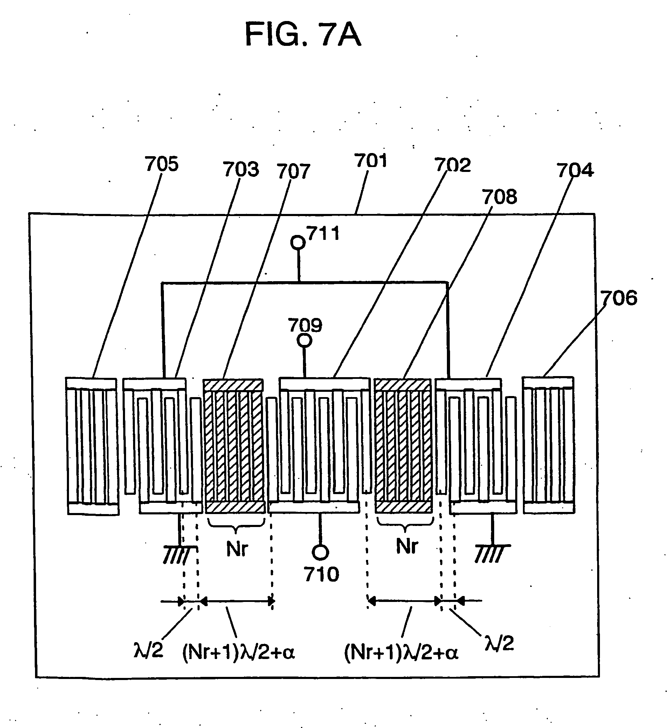

Fig. 7A schematically illustrates a surface acoustic wave filter in accordance with the second exemplary embodiment.

In Fig. 7A, a pattern of interdigital electrodes each constructed of opposed electrode fingers is formed on piezoelectric substrate 701, whereby a surface acoustic wave is excited.

The surface acoustic wave filter formed is a longitudinally coupled type including first, second and third IDT electrodes 702, 703, 704 and first, second, third and fourth reflector electrodes 707, 708, 705, 706 on piezoelectric substrate 701.

The second embodiment differs from the first embodiment in that first reflector electrode 707 is disposed between first and second IDT electrodes 702, 703 and that second reflector electrode 708 is disposed between first and third IDT electrodes 702, 704. This arrangement can reduce discontinuity of a periodic structure defined by electrode finger pitches and can hence reduce loss of the surface acoustic wave filter. Third and fourth reflector electrodes 705, 706 of the present embodiment are similar in structure to respective reflector electrodes 105, 106 of the first embodiment.

In the above-mentioned surface acoustic wave filter, the upper electrode fingers of first IDT electrode 702 are coupled to first terminal 709 of a balanced port, while the lower electrode fingers of this IDT electrode 702 are coupled to second terminal 710 of the balanced port. The upper electrode fingers of second IDT electrode 703 are coupled to unbalanced port 711, while the lower electrode fingers thereof are grounded. Similarly, the upper electrode fingers of the third IDT electrode are coupled to unbalanced port 711, while the lower electrode fingers thereof are grounded. This surface acoustic wave filter thus includes the unbalanced and balanced ports.

Throughout IDT electrodes 702, 703, 704 , the electrode finger pitch is set at λ/2. A spacing between an excitation center of first IDT electrode 702 and an excitation center of second IDT electrode 703 is deviated by amount α from the λ/2 periodic structure. Similarly, a spacing between the excitation center of first IDT electrode 702 and an excitation center of third IDT electrode 704 is deviated by amount α from the λ/2 periodic structure.

A description is now provided of a case where the deviating amount is -λ/4. When the number of electrode fingers of each of the first and second reflector electrodes is Nr, the distance between centers of the respective fingers nearest to each other in first and second IDT electrodes 702, 703 as well as centers of the respective fingers nearest to each other in first and third IDT electrodes 702, 704 is {(Nr+1)λ/2-λ/4}.

In cases where the electrode fingers of each of first and second reflector electrodes 707, 708 are arranged at equal pitches, every electrode finger pitch of these reflector electrodes 707, 708 is {(Nr+1)λ/2-λ/4}/(Nr+1) because there exist (Nr+1) finger-to-finger spacings in each of these reflector electrodes 707, 708. Therefore, the ratio of the electrode finger pitch of each of IDT electrodes 702, 703, 704 to the electrode finger pitch of each of reflector electrodes 707, 708 is 1-1/{2(Nr+1)}. With reflector electrodes 707, 708 each having four or more electrode fingers, every electrode finger pitch of reflector electrodes 707, 708 is 0.9λ/2 or more, and the discontinuity can be limited to within 10%.

In cases where the deviating amount is +λ/4, the ratio of the electrode finger pitch of each of IDT electrodes 702, 703, 704 to the electrode finger pitch of each of reflector electrodes 707, 708 is 1+1/{2(Nr+1)}. With reflector electrodes 707, 708 each having four or more electrode fingers, every electrode finger pitch of reflector electrodes 707, 708 is 1.1λ/2 or less, and the discontinuity can be limited to within 10%.

In the present embodiment, the electrode fingers of first and second reflector electrodes 707, 708 are arranged at equal pitches. However, those electrode fingers may be arranged at pitches varying stepwise such as noted in the first embodiment, or the reflector electrode may have two or more different kinds of electrode finger pitches.

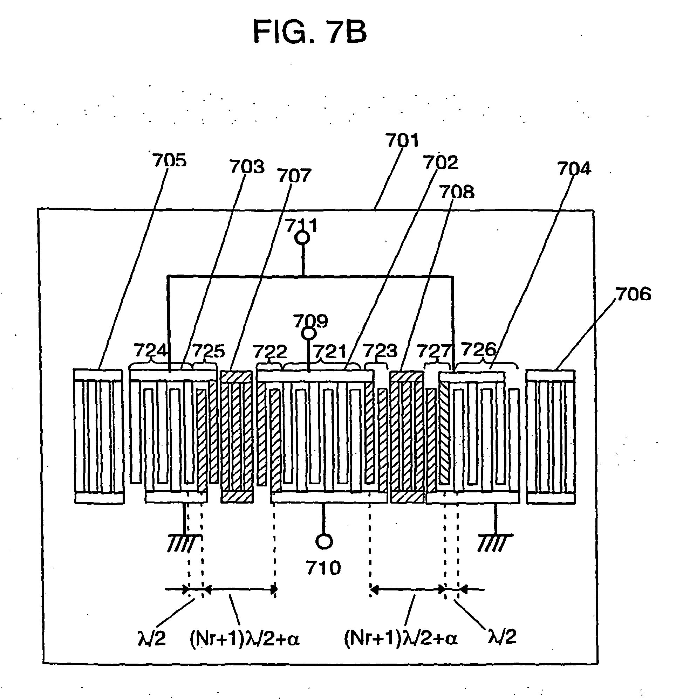

The electrode finger pitches of first and second reflector electrodes 707, 708 differ from those of first, second and third IDT electrodes 702, 703, 704. However, IDT electrodes 702, 703, 704 may each be divided into a plurality of regions to change the electrode finger pitches of each region adjacent to reflector electrode 707 or 708. As shown in Fig. 7B, first IDT electrode 702 is divided into three regions including first excitation region 721, second excitation region 722 and third excitation region 723. In first IDT electrode 702, first excitation region 721 is located between second and third excitation regions 722, 723. Second IDT electrode 703 is divided into two regions including first excitation region 724 and second excitation region 725. Second excitation region 725 of second IDT electrode 703 is located close to first IDT electrode 702. Third IDT electrode 704 is divided into two regions including first excitation region 726 and second excitation region 727. Second excitation region 727 of third IDT electrode 704 is located close to first IDT electrode 702.

Throughout first excitation regions 721, 724, 726 of IDT electrodes 702, 703, 704, a spacing (electrode finger pitch) between respective centers of the adjacent electrode fingers is set at λ/2, where λ is the wavelength of the surface acoustic wave to be excited.

A spacing between an excitation center of first excitation region 721 of first IDT electrode 702 and an excitation center of first excitation region 724 of second IDT electrode 703 is deviated by a certain amount from the λ/2 periodic structure. Similarly, a spacing between the excitation center of first excitation region 721 of first IDT electrode 702 and an excitation center of first excitation region 726 of third IDT electrode 704 is deviated by the certain amount from the λ/2 periodic structure. In other words, optimizing the electrode finger pitches of first and second reflector electrodes 707, 708 and the electrode finger pitches of regions 722, 723, 725, 727 of the IDT electrodes as a whole affords the similar advantages.

The number of electrode fingers of the reflector electrode and the number of fingers of the IDT electrode are not limited specifically and are optimized for desired filter characteristics. Also the reflector electrodes shown in Figs. 7A and 7B may be grounded.

The surface acoustic wave filter of the present embodiment is configured to have the balanced and unbalanced ports, so that if, similarly to the first embodiment, the ratio between the adjacent electrode finger pitches ranges from 0.8 to 1.2 in consideration of an advantage obtained by improving balancing characteristics, the loss can be reduced as a result of reduced discontinuity, and the balancing characteristics can be improved.

The first IDT electrode is deviated by -λ/4 or +λ/4 from the second and third IDT electrodes. However, the deviating amount is not limited to these values. The deviating amount is one of parameters determining a passband of the filter and is therefore optimized in accordance with the desired filter characteristics.

The present embodiment has referred to the electrode finger pitch only. As in the first embodiment, in addition to the electrode finger pitch, a metallization ratio of the electrode finger can be changed, too.

The present embodiment has referred to the balanced and unbalanced ports. However, the ports may both be unbalanced or balanced.

As long as the electrode finger pitches of the surface acoustic wave filter are set to define the periodic structure of the present invention, the similar advantages can be obtained even when an input/output direction is reversed.

The application of the present invention to a filter using a leaky surface acoustic wave can enhance the effect of reducing bulk radiation loss.

### THIRD EXEMPLARY EMBODIMENT

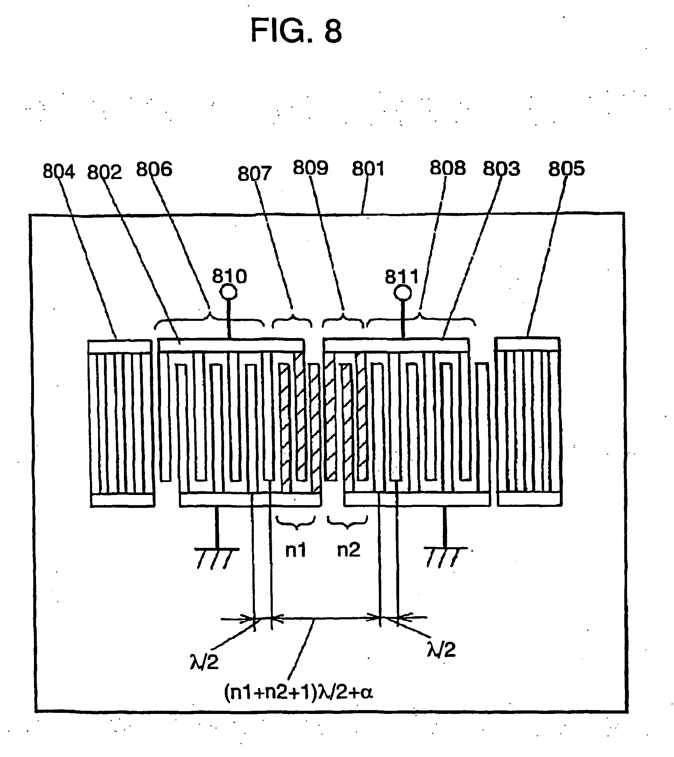

Fig. 8 schematically illustrates a surface acoustic wave filter in accordance with the third exemplary embodiment of the present invention.

In Fig. 8, a pattern of interdigital electrodes each constructed of opposed electrode fingers is formed on piezoelectric substrate 801, whereby a surface acoustic wave can be excited. The surface acoustic wave filter formed is a longitudinal mode type including first and second IDT electrodes 802, 803 and first and second reflector electrodes 804, 805 on piezoelectric substrate 801.

The third embodiment of this invention differs from the first embodiment in that the surface acoustic wave filter has the two IDT electrodes. This can reduce discontinuity of a periodic structure defined by electrode finger pitches, and can hence reduce loss of the surface acoustic wave filter.

In the above-mentioned surface acoustic wave filter, the upper electrode fingers of first IDT electrode 802 are coupled to unbalanced port 810, while the lower electrode fingers of this IDT electrode 802 are grounded. The upper electrode fingers of second IDT electrode 803 are coupled to unbalanced port 811, while the lower electrode fingers thereof are grounded. This surface acoustic wave filter thus includes the ports both unbalanced.

First IDT electrode 802 is divided into two regions including first excitation region 806 and second excitation region 807. Second excitation region 807 of this IDT electrode 802 is located adjacent to second IDT electrode 803.

Similarly, second IDT electrode 803 is divided into two regions including first excitation region 808 and second excitation region 809. Second excitation region 809 of this IDT electrode 803 is located adjacent to first IDT electrode 802.

Throughout first excitation regions 806, 808 of first and second IDT electrodes 802, 803, the electrode finger pitch is set at λ/2. A spacing between an excitation center of first excitation region 806 of first IDT electrode 802 and an excitation center of first excitation region 808 of second IDT electrode 803 is deviated by amount α from the λ/2 periodic structure. In first IDT electrode 802, the electrode finger pitch of first excitation region 806 differs from each electrode finger pitch of second excitation region 807 so that the ratio between these electrode finger pitches ranges from 0.9 to 1.2

In second IDT electrode 803, the electrode finger pitch of first excitation region 808 differs from each electrode finger pitch of second excitation region 809 so that the ratio between these electrode finger pitches ranges from 0.9 to 1.2. In other words, all the electrode finger pitches of the surface acoustic wave filter range from 0.9λ/2 to 1.2λ/2 to define a substantially periodic structure.

A description is now provided of a case where second excitation regions 807, 809 of IDT electrodes 802, 803 have n1 electrode fingers and n2 electrode fingers, respectively. When deviating amount α=-λ/4, the distance between centers of the respective fingers nearest to each other in first excitation regions 806, 808 of first and second IDT electrodes 802, 803 is {(n1+n2+1)λ/2-λ/4}. In cases where the electrode fingers of second excitation regions 807, 809 of IDT electrodes 802, 803 are arranged at equal pitches, there exist (n1+n2+1) finger-to-finger spacings in these regions 807, 809, so that every electrode finger pitch of these regions 807, 809 is {(n1+n2+1)λ/2-λ/4}/(n1+n2+1). Therefore, the ratio of the electrode finger pitch of first excitation region 806 to the electrode finger pitch of second excitation region 807 of first IDT electrode 802 as well as the ratio of the electrode finger pitch of first excitation region 808 to the electrode finger pitch of second excitation region 809 of second IDT electrode 803 is 1-1/{2(n1+n2+1)}.

With the sum (n1+n2) of electrode fingers in second excitation regions 807, 809 of IDT electrodes 802, 803 being four or more, every electrode finger pitch of these regions 807, 809 is 0.9λ/2 or more, and the discontinuity can be limited to within 10%.

When the deviating amount is +λ/4, the ratio of the electrode finger pitch of the primary exitation region to the electrode finger pitch of the secondary exitation region is 1+1/{2(n1+n2+1)}.

With the sum (n1+n2) of electrode fingers in second excitation regions 807, 809 of IDT electrodes 802, 803 being four or more, every electrode finger pitch of these regions 807, 809 is 1.1λ/2 or less, and the discontinuity can be limited to within 10%.

In the present embodiment, the electrode fingers of second excitation regions 807, 809 of first and second IDT electrodes 802, 803 are arranged at equal pitches. However, those electrode fingers may be arranged at pitches varying stepwise such as noted in the first embodiment, or second excitation regions 807, 809 may each include two or more different kinds of electrode finger pitches different from the λ/2 pitches.

The first excitation region of the first IDT electrode is deviated by -λ/4 or +λ/4 from the first excitation region of second IDT electrodes. However, the deviating amount is not limited to these values. The deviating amount is one of parameters determining a passband of the filter and is therefore optimized in accordance with desired filter characteristics.

The present embodiment has referred to the electrode finger pitch only. As in the first embodiment, in addition to the electrode finger pitch, a metallization ratio of the electrode finger can be changed, too.

The present embodiment has referred to the ports both unbalanced. However, the ports may not necessarily be unbalanced.

As long as the electrode finger pitches of the surface acoustic wave filter are set to define the periodic structure of the present invention, the similar advantages can be obtained even when an input/output direction is reversed.

The application of the present invention to a filter using a leaky surface acoustic wave can enhance the effect of reducing bulk radiation loss.

### FOURTH EXEMPLARY EMBODIMENT

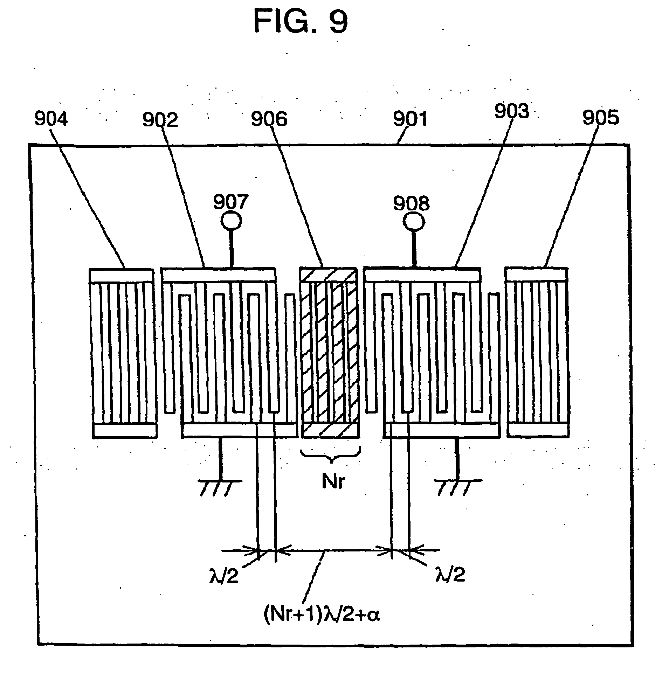

Fig. 9 schematically illustrates a surface acoustic wave filter in accordance with the fourth exemplary embodiment.

In Fig. 9, a pattern of interdigital electrodes each constructed of opposed electrode fingers is formed on piezoelectric substrate 901, whereby a surface acoustic wave can be excited. The surface acoustic wave filter formed is a longitudinal mode type including first and second IDT electrodes 902, 903 and first, second and third reflector electrodes 904, 905, 906 on piezoelectric substrate 901.

The fourth embodiment differs from the third embodiment in that third reflector electrode 906 is disposed between first and second IDT electrodes 902, 903. This can reduce discontinuity of a periodic structure defined by electrode finger pitches and can hence reduce loss of the surface acoustic wave filter.

In the above-mentioned surface acoustic wave filter, the upper electrode fingers of first IDT electrode 902 are coupled to unbalanced port 907, while the lower electrode fingers of this IDT electrode 902 are grounded. The upper electrode fingers of second IDT electrode 903 are coupled to unbalanced port 908, while the lower electrode fingers thereof are grounded. This surface acoustic wave filter thus includes the ports both unbalanced.

Throughout first and second IDT electrodes 902, 903, the electrode finger pitch is set at λ/2. A spacing between an excitation center of first IDT electrode 902 and an excitation center of second IDT electrode 903 is deviated by a certain amount from the periodic structure. A description is now provided of a case where the deviating amount is -λ/4. When the number of electrode fingers of the third reflector electrode is Nr, the distance between centers of the respective fingers nearest to each other in IDT electrodes 902, 903 is {(Nr+1)λ/2-λ/4}. In cases where the electrode fingers of third reflector electrode 906 are arranged at equal pitches, there exist (Nr+1) finger-to-finger spacings in this reflector electrode 906, so that every electrode finger pitch of this reflector electrode 906 is {(Nr+1)λ/2-λ/4}/(Nr+1).

Therefore, the ratio of the electrode finger pitch of each of IDT electrodes 902, 903 to the electrode finger pitch of third reflector electrode 906 is 1-1/{2(Nr+1)}. With third reflector electrode 906 having four or more electrode fingers, every electrode finger pitch of this reflector electrode 906 is 0.9λ/2 or more, and the discontinuity can be limited to within 10%.

In cases where the deviating amount is +λ/4, the ratio of the electrode finger pitch of each of IDT electrodes 902, 903 to the electrode finger pitch of third reflector electrode 906 is 1+1/{2(Nr+1)}. With reflector electrode 906 having four or more electrode fingers, every electrode finger pitch of this reflector electrode 906 is 1.1λ/2 or less, and the discontinuity can be limited to within 10%.

In the present embodiment, the electrode fingers of third reflector electrode 906 are arranged at equal pitches. However, those electrode fingers may be arranged at pitches varying stepwise such as noted in the first embodiment.

The electrode finger pitches of third reflector electrode 906 differ from those of first and second IDT electrodes 902, 903. However, IDT electrodes 902, 903 may each be divided into a plurality of regions to change the electrode finger pitches of each region adjacent to reflector electrode 906. In other words, optimizing the electrode finger pitches of this reflector electrode and the electrode finger pitches of the regions adjacent to this reflector electrode as a whole affords the similar advantages.

The first IDT electrode is deviated by -λ/4 or +λ/4 from the second IDT electrode. However, the deviating amount is not limited to these values. The deviating amount is one of parameters determining a passband of the filter and is therefore optimized in accordance with desired filter characteristics.

The present embodiment has referred to the electrode finger pitch only. As in the first embodiment, in addition to the electrode finger pitch, a metallization ratio of the electrode finger can be changed, too.

The present embodiment has referred to the ports both unbalanced. However, the ports may not necessarily be unbalanced.

The application of the present invention to a filter using a leaky surface acoustic wave can enhance the effect of reducing bulk radiation loss.

Further, as long as the electrode finger pitches of the surface acoustic wave filter are set to define the periodic structure of the present invention, the similar advantages can be obtained even when an input/output direction is reversed.

### FIFTH EXEMPLARY EMBODIMENT

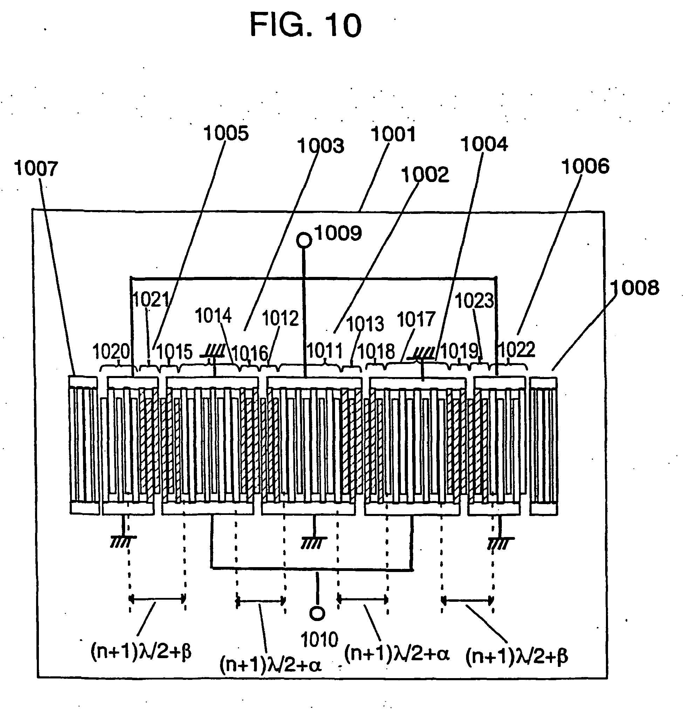

Fig. 10 schematically illustrates a surface acoustic wave filter in accordance with the fifth exemplary embodiment.

In Fig. 10, a pattern of interdigital electrodes each constructed of opposed electrode fingers is formed on piezoelectric substrate 1001, whereby a surface acoustic wave can be excited. The surface acoustic wave filter formed is a longitudinally coupled type including first, second, third, fourth and fifth IDT electrodes 1002, 1003, 1004, 1005, 1006 and first and second reflector electrodes 1007, 1008 on piezoelectric substrate 1001.

In the above-mentioned surface acoustic wave filter, the upper electrode fingers of first, fourth and fifth IDT electrodes 1002, 1005, 1006 are coupled to unbalanced port 1009, while the lower electrode fingers of these IDT electrodes 1002, 1005, 1006 are grounded. The lower electrode fingers of second and third IDT electrodes 1003, 1004 are coupled to unbalanced port 1010, while the upper electrode fingers thereof are grounded. The surface acoustic wave filter thus includes five IDT electrodes and the ports both unbalanced.

First IDT electrode 1002 is divided into three regions including first excitation region 1011, second excitation region 1012 and third excitation region 1013. In this IDT electrode 1002, first excitation region 1011 is located between second and third excitation regions 1012, 1013.

Second IDT electrode 1003 is divided into three regions including first excitation region 1014, second excitation region 1015 and third excitation region 1016. In this IDT electrode 1003, first excitation region 1014 is located between second and third excitation regions 1015, 1016.

Third IDT electrode 1004 is divided into three regions including first excitation region 1017, second excitation region 1018 and third excitation region 1019. In this IDT electrode 1004, first excitation region 1017 is located between second and third excitation regions 1018, 1019.

Fourth IDT electrode 1005 is divided into two regions including first excitation region 1020 and second excitation region 1021. Second excitation region 1021 of this IDT electrode 1005 is located adjacent to second IDT electrode 1003.

Fifth IDT electrode 1006 is divided into two regions including first excitation region 1022 and second excitation region 1023. Second excitation region 1023 of this IDT electrode 1006 is located adjacent to third IDT electrode 1004.

Throughout first excitation regions 1011, 1014, 1017, 1020, 1022 of first through fifth IDT electrodes 1002, 1003, 1004, 1005, 1006, a spacing (an electrode finger pitch) between respective centers of the adjacent electrode fingers is set at λ/2, where λ is the wavelength of the surface acoustic wave to be excited.

A spacing between an excitation center of first excitation region 1011 of first IDT electrode 1002 and an excitation center of first excitation region 1014 of second IDT electrode 1003 is deviated by amount α from the λ/2 periodic structure. Similarly, a spacing between the excitation center of first excitation region 1011 of first IDT electrode 1002 and an excitation center of first excitation region 1017 of third IDT electrode 1004 is deviated by amount α from the λ/2 periodic structure.

A spacing between the excitation center of first excitation region 1014 of second IDT electrode 1003 and an excitation center of first excitation region 1020 of fourth IDT electrode 1005 is deviated by amount β from the λ/2 periodic structure. Similarly, a spacing between the excitation center of first excitation region 1017 of third IDT electrode 1004 and an excitation center of first excitation region 1022 of fifth IDT electrode 1006 is deviated by amount β from the λ/2 periodic structure.

As noted in the above-described configuration, deviating the first excitation regions of the first through fifth IDT electrodes by the certain amount affords characteristics representative of the longitudinal mode surface acoustic wave filter using a plurality of modes. Further, optimizing the electrode finger pitches of the regions (secondary excitation regions) other than the first excitation regions of the first through fifth IDT electrodes reduces discontinuity, so that all the electrode fingers form a substantially continuous periodic structure, thus reducing loss caused by bulk radiation resulting from discontinuity of acoustic impedance.

The deviating amount of the first excitation region is set at α or β. However, the deviating amount is optimized in accordance with desired filter characteristics since the deviating amount is one of parameters determining a passband of the filter.

In the present embodiment, each area having the electrode finger pitches different from the λ/2 pitches may be formed of a reflector electrode or a combination of the reflector electrode and the secondary excitation regions of the IDT electrodes, as described in the second embodiments.

The present embodiment has referred to the ports both unbalanced. However, at least one of the ports may be balanced.

### SIXTH EXEMPLARY EMBODIMENT

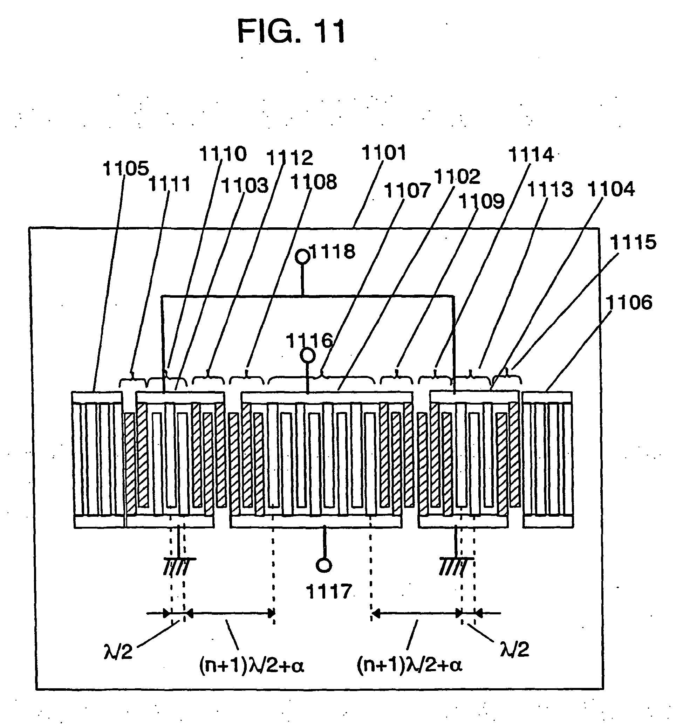

Fig. 11 schematically illustrates a surface acoustic wave filter in accordance with the sixth exemplary embodiment.

In Fig. 11, a pattern of interdigital electrodes each constructed of opposed electrode fingers is formed on piezoelectric substrate 1101, whereby a surface acoustic wave can be excited. The surface acoustic wave filter formed is a longitudinally coupled type including first, second and third IDT electrodes 1102, 1103, 1104 and first and second reflector electrodes 1105, 1106 on piezoelectric substrate 1101.

In the above-mentioned surface acoustic wave filter, the upper electrode fingers of first IDT electrode 1102 are coupled to first terminal 1116 of a balanced port, while the lower electrode fingers of this IDT electrode 1102 are coupled to second terminal 1117 of the balanced port. The upper electrode fingers of second IDT electrode 1103 are coupled to unbalanced port 1118, while the lower electrode fingers thereof are grounded. Similarly, the upper electrode fingers of third IDT electrode 1104 are coupled to unbalanced port 1118, while the lower electrode fingers thereof are grounded. This surface acoustic wave filter thus includes the unbalanced and balanced ports.

First IDT electrode 1102 is divided into three regions including first excitation region 1107, second excitation region 1108 and third excitation region 1109. In this IDT electrode 1102, first excitation region 1107 is located between second and third excitation regions 1108, 1109.

Second IDT electrode 1103 is divided into three regions including first excitation region 1110, second excitation region 1111 and third excitation region 1112. In this IDT electrode 1103, first excitation region 1110 is located between second and third excitation regions 1111, 1112, and second excitation region 1111 is located adjacent to first reflector electrode 1105.

Third IDT electrode 1104 is divided into three regions including first excitation region 1113, second excitation region 1114 and third excitation region 1115. In this IDT electrode 1104, first excitation region 1113 is located between second and third excitation regions 1114, 1115, and third excitation region 1115 is located adjacent to second reflector electrode 1106.

Throughout first excitation regions 1107, 1110, 1113 of IDT electrodes 1102, 1103, 1104, a spacing (an electrode finger pitch) between respective centers of the adjacent electrode fingers is set at λ/2, where λ is the wavelength of the surface acoustic wave to be excited.

A spacing between an excitation center of first excitation region 1107 of first IDT electrode 1102 and an excitation center of first excitation region 1110 of second IDT electrode 1103 is deviated by amount α from the λ/2 periodic structure. Similarly, a spacing between the excitation center of first excitation region 1107 of first IDT electrode 1102 and an excitation center of first excitation region 1113 of third IDT electrode 1104 is deviated by amount α from the λ/2 periodic structure.

The reflector electrodes have electrode finger pitches different from those of first excitation regions 1107, 1110, 1113 of IDT electrodes 1102, 1103, 1104. The excitation center of first excitation region 1110 of the second IDT electrode is deviated by a certain amount from a reflection center of first reflector electrode 1105. Similarly, the excitation center of first excitation region 1113 of the third IDT electrode is deviated by a certain amount from a reflection center of second reflector electrode 1106. The deviating amounts are optimized in accordance with a passband frequency response.

Here, the distance between the excitation center of first excitation region 1110 of the second IDT electrode and the reflection center of first reflector electrode 1105, and the distance between the excitation center of first excitation region 1113 of the third IDT electrode and the reflection center of second reflector electrode 1106 are optimized by setting electrode finger pitches different from the λ/2 pitches throughout second and third excitation regions 1111, 1115 of second and third IDT electrodes 1103, 1104. This can reduce discontinuity and also reduce discontinuity that results when the electrode finger pitches of the reflector electrodes differ from those of first excitation regions 1107, 1110, 1113 of IDT electrodes 1102, 1103, 1104.

As noted in the above-described configuration, deviating the first excitation regions of the first, second and third IDT electrodes by the certain amount affords characteristics representative of the longitudinal mode surface acoustic wave filter using primary and tertiary modes. Further, optimizing the electrode finger pitches of the regions other than the first excitation regions of the first, second and third IDT electrodes reduces the discontinuity, so that all the electrode fingers form a substantially continuous periodic structure, thus reducing loss caused by bulk radiation resulting from discontinuity of acoustic impedance.

The description has referred to the unbalanced and balanced ports. However, the ports may both be unbalanced.

In the present embodiment, all of the secondary excitation regions of the IDT electrodes and the reflector electrodes have the electrode finger pitches different from the λ/2 pitches. However, the electrode finger pitches of reflector electrodes 1105, 1106 and the regions of the IDT electrodes that are adjacent to respective reflector electrodes 1105, 1106 may be the only finger pitches different from the λ/2 pitches.

The present embodiment may be applied to not only the filter including the three IDT electrodes but also filters including those, such as described in the third, fourth and fifth embodiments, which include two IDT electrodes and five IDT electrodes, respectively and a filter having IDT electrodes to the number other than two, three and five. With such an IDT electrode structure also, by optimizing electrode finger pitches to reduce discontinuity of the propagation path, the similar advantages can be obtained.

In each of the foregoing embodiments, some of the electrode finger pitches of the IDT electrode or the electrode finger pitches of the reflector electrode are set different from the λ/2 pitches for reduced discontinuity. However, both the reflector electrode and the IDT electrode may include the electrode finger pitches different from the λ/2 pitches for reduced discontinuity.

### INDUSTRIAL APPLICABILITY

The present invention proposes a structure for minimizing discontinuity between IDT electrodes in a surface acoustic wave filter in which a region having λ/2 electrode finger pitches of at least one IDT electrode is phase-shifted from that of other IDT electrode by a certain amount in accordance with a desired passband frequency response, and as a result realizes a low loss surface acoustic wave filter. By adopting this surface acoustic wave filter, a sensitivity of a high-frequency apparatus such as a mobile communication apparatus can be improved.

## Claims

1. A longitudinally coupled surface acoustic wave filter comprising:
a piezoelectric substrate (101); and
a plurality of interdigital transducer electrodes (IDT electrodes) (102,103,104) and a plurality of reflector electrodes (105,106) disposed on the piezoelectric substrate,
wherein each of the IDT electrodes is an interdigital electrode (102,103,104) including a plurality of electrode fingers forming two interlocking comb shaped patterns,
wherein the IDT electrodes (102,103,104) and the reflector electrodes (105,106) are arranged in close relation along a propagation direction of a surface acoustic wave,
wherein the IDT electrode (102,103,104) includes a primary excitation region (107,110,112) having λ/2 electrode finger pitches, where λ is a wavelength of the surface acoustic wave,
wherein the primary excitation region of at least one of the IDT electrodes (102,103,104) is phase-shifted from the primary excitation region of another IDT electrode by a certain amount in accordance with a desired passband frequency response,
**characterized in**
**that** each of one of the IDT electrodes (102,103,104) and another one of the IDTelectrodes (102,103,104) disposed adjacent to each other includes a secondary excitation region (108,109,111,113) having electrode finger pitches different from the λ/2 pitches, on sides thereof adjacent to each other, wherein the secondary excitation region is a part of said each of said one of the IDT electrodes and said another of IDT electrodes each forming the two interlocking comb shaped patterns and/or
**that** the reflector electrode having two or more different kinds of electrode finger pitches different from the λ/2 pitches is disposed between the IDT electrodes disposed adjacent to each other.

2. The surface acoustic wave filter according to claim 1, wherein all of the electrode finger pitches of the surface acoustic wave filter fall within a range of 0.8λ/2 to 1.2λ/2.

3. The surface acoustic wave filter according to claim 1, wherein the surface acoustic wave is a leaky surface acoustic wave.

4. The surface acoustic wave filter according to claim 1, wherein the IDT electrode (1103, 1104) adjacent to an outermost reflector electrode (1105, 1106) of the reflector electrodes includes, on a side thereof adjacent to the outermost reflector electrode, a secondary excitation region (1111, 1113) having electrode finger pitches different from the λ/2 pitches.

5. The surface acoustic wave filter according to claim 1, wherein:
the IDT electrode (102,103,104) includes a secondary excitation region (108,109,111,113) having electrode finger pitches different from the λ/2 pitches, and
at least one of the reflector electrodes (105,106) has electrode finger pitches different from the λ/2 pitches.

6. The surface acoustic wave filter according to claim 1, wherein:
the plurality of IDT electrodes (802,803) includes a first IDT electrode (802) and a second IDT electrode (803) adjacent to the first IDT electrode (802),
the reflector electrodes (804,805) include a first reflector electrode (804) adjacent to the first IDT electrode (802) and a second reflector electrode (805) adjacent to the second IDT electrode (803),
the respective primary excitation regions (806,808) of the first and second IDT electrodes (802,803) are phase-shifted from each other by the certain amount in accordance with the desired passband frequency response, and
the first and second IDT electrodes include, on the respective adjacent sides of the first and second IDT electrodes, the respective secondary excitation regions (807,809) each having the electrode finger pitches different from the λ/2 pitches.

7. The surface acoustic wave filter according to claim 1, wherein:
the plurality of IDT electrodes (102,103,104) includes a first IDT electrode (102) and a second and third IDT electrodes (103,104) adjacent to the respective sides of the first IDT electrode,
the plurality of reflector electrodes includes a first and second reflector electrodes (105,106) disposed on respective outer sides of the three IDT electrodes (102,103,104),
the primary excitation region of the first IDT electrode (102) is phase-shifted from the respective primary excitation regions (107) of the second and third IDT electrodes (103,104) by the certain amount in accordance with the desired passband frequency response, and
the IDT electrode (102,103,104) includes, on the side thereof adjacent to another IDT electrode, the secondary excitation region (108,109,111,113) having the electrode finger pitches different from the λ/2 pitches.

8. The surface acoustic wave filter according to claim 1, wherein:
the IDT electrodes include five IDT electrodes (1002,1003,1004,1005,1006) arranged in close relation,
the primary excitation region (1011,1014,1017,1020,1022) of the IDT electrode is phase-shifted by the certain amount in accordance with the desired passband frequency response, and
the IDT electrode (1002,1003,1004,1005,1006) includes, on the side thereof adjacent to another IDT electrode, the secondary excitation region (1012,1013,1015,1016,1018,1019, 1021,1023) having the electrode finger pitches different from the λ/2 pitches.

9. The surface acoustic wave filter according to any one of claims 6 to 8, wherein the electrode finger pitches of at least one of the secondary excitation regions include two or more different kinds of electrode finger pitches.

10. The surface acoustic wave filter according to any one of claims 6 to 8, wherein the electrode finger pitches of at least one of the secondary excitation regions vary stepwise.

11. The surface acoustic wave filter according to any one of claims 6 to 8, wherein the electrode finger pitches of at least one of the secondary excitation regions differ from one another and increase stepwise.

12. The surface acoustic wave filter according to any one of claims 6 to 8, wherein the electrode finger pitches of at least one of the secondary excitation regions are all equal.

13. The surface acoustic wave filter according to any one of claims 6 to 8, wherein the number of electrode fingers all of the secondary excitation regions of at least one of the IDT electrodes accounts for 1/3 or less of the total number of electrode fingers of the IDT electrode.

14. The surface acoustic wave filter according to claim 1, wherein:
the plurality of IDT electrodes includes first and second IDT electrodes (902,903),
at least one of the reflector electrodes (906) is disposed between the first and second IDT electrodes (902,903),
the respective primary excitation regions of the first and second IDT electrodes are phase-shifted from each other by the certain amount in accordance with the desired passband frequency response, and
the reflector electrode (906) has electrode finger pitches different from the λ/2 pitches.

15. The surface acoustic wave filter according to claim 14, wherein the electrode finger pitches of the reflector electrode (906) include two or more different kinds of electrode finger pitches.

16. The surface acoustic wave filter according to claim 14, wherein the electrode finger pitches of the reflector electrode (906) differ from one another and increase stepwise.

17. The surface acoustic wave filter according to claim 1, wherein:
the plurality of IDT electrodes includes first, second and third IDT electrodes (702,703, 704),
the plurality of reflector electrodes includes first and second reflector electrodes (707,708),
the second IDT electrode (703) is located on a first side of the first IDT electrode (702) across the first reflector electrode (707),
the third IDT electrode (704) is located on a second side of the first IDT electrode (702) across the second reflector electrode (708),
the primary excitation region of the first IDT electrode (702) is phase-shifted from the respective primary excitation regions of the second and third IDT electrodes (703,704) by the certain amount in accordance with the desired passband frequency response, and
each of the first and second reflector electrodes (707,708) has electrode finger pitches different from the λ/2 pitches.

18. The surface acoustic wave filter according to claim 17, wherein the electrode finger pitches of at least one of the first and second reflector electrodes (707,708) include two or more different kinds of electrode finger pitches.

19. The surface acoustic wave filter according to claim 17, wherein the electrode finger pitches of at least one of the first and second reflector electrodes (707,708) differ from one another and increase stepwise.

20. The surface acoustic wave filter according to claim 1, wherein:
the plurality of IDT electrodes includes at least five IDT electrodes (1002,1003,1004,1005, 1006),
the plurality of reflector electrodes includes at least four reflector electrodes each disposed between the IDT electrodes (1002,1003,1004,1005,1006),
the primary excitation region (1011,1014,1017,1020,1022) of the IDT electrode is phase-shifted from the primary excitation region of another IDT electrode by the certain amount in accordance with the desired passband frequency response, and
at least one of the reflector electrodes has electrode finger pitches different from the λ/2 pitches.

21. The surface acoustic wave filter according to claim 20, wherein the electrode finger pitches of the reflector electrode include two or more different kinds of electrode finger pitches.

22. The surface acoustic wave filter according to claim 20, wherein the electrode finger pitches of the reflector electrode differ from one another and increase stepwise.

## Patentansprüche

1. In Längsrichtung gekoppeltes Oberflächenwellenfilter, das umfasst:
ein piezoelektrisches Substrat (101); und
eine Vielzahl von Interdigitalwandler-Elektroden (102, 103, 104) sowie eine Vielzahl von Reflektorelektroden (105, 106), die auf dem piezoelektrischen Substrat angeordnet sind,
wobei jede der Interdigitalwandler-Elektroden eine Interdigitalelektrode (102, 103, 104) ist, die eine Vielzahl von Elektrodenfingern enthält, die zwei ineinandergreifende kammförmige Muster bilden,
wobei die Interdigitalwandler-Elektroden (102, 103, 104) und die Reflektorelektroden (105, 106) in einer Ausbreitungsrichtung einer Oberflächenwelle nahe beieinander angeordnet sind,
wobei die Interdigitalwandler-Elektrode (102, 103, 104) einen primären Anregungsbereich (107, 110, 112) mit Elektrodenfinger-Abständen von λ/2 enthält, wobei λ eine Wellenlänge der Oberflächenwelle ist,
wobei der primäre Anregungsbereich wenigstens einer der Interdigitalwandler-Elektroden (102, 103, 104) gegenüber dem primären Anregungsbereich einer anderen Interdigitalwandler-Elektrode um ein bestimmtes Maß entsprechend einem gewünschten Durchlassfrequenzverhalten phasenverschoben ist,
**dadurch gekennzeichnet, dass**
jede der einen der Interdigitalwandler-Elektroden (102, 103, 104) und der anderen der Interdigitalwandler-Elektroden (102, 103, 104), die aneinander angrenzend angeordnet sind, einen sekundären Anregungsbereich (108, 109, 111, 113) enthält, der von den λ/2-Abständen verschiedene Elektrodenfinger-Abstände an aneinandergrenzenden Seiten derselben aufweist, wobei der sekundäre Anregungsbereich ein Teil jeder der einen der Interdigitalwandler-Elektroden und der anderen der Interdigitalwandler-Elektroden ist, die jeweils die zwei ineinandergreifenden kammförmigen Muster bilden, und/oder die Reflektorelektrode, die zwei oder mehr verschiedene Arten von Elektrodenfinger-Abständen aufweist, die sich von den λ/2-Abständen unterscheiden, zwischen den Interdigitalwandler-Elektroden angeordnet ist, die aneinander angrenzend angeordnet sind.

2. Oberflächenwellenfilter nach Anspruch 1, wobei alle der Elektrodenfinger-Abstände des Oberflächenwellenfilters in einen Bereich von 0,8 λ/2 bis 1,2 λ/2 fallen.

3. Oberflächenwellenfilter nach Anspruch 1, wobei die Oberflächenwelle eine Oberflächen-Leckwelle ist.

4. Oberflächenwellenfilter nach Anspruch 1, wobei die Interdigitalwandler-Elektrode, die (1103, 1104) an eine äußerste Reflektorelektrode (1105, 1006) der Reflektorelektroden angrenzt, an einer Seite derselben, die an die äußerste Reflektorelektrode angrenzt, einen sekundären Anregungsbereich (1111, 1113) enthält, der von den λ/2-Abständen verschiedene Elektrodenfinger-Abstände aufweist.

5. Oberflächenwellenfilter nach Anspruch 1, wobei:
die Interdigitalwandler-Elektrode (102, 103, 104) einen sekundären Anregungsbereich (108, 109, 111, 113) enthält, der von den λ/2-Abständen verschiedene Elektrodenfinger-Abstände aufweist, und
wenigstens eine der Reflektorelektroden (105, 106) von den λ/2-Abständen verschiedene Elektrodenfinger-Abstände aufweist.

6. Oberflächenwellenfilter nach Anspruch 1, wobei:
die Vielzahl von Interdigitalwandler-Elektroden (802, 803) eine erste Interdigitalwandler-Elektrode (802) und eine zweite Interdigitalwandler-Elektrode (803) an die erste Interdigitalwandier-Elektrode (802) angrenzend enthält,
die Reflektorelektroden (804, 805) eine erste Reflektorelektrode (804) an die erste Interdigitalwandler-Elektrode (802) angrenzend und eine zweite Reflektorelektrode (805) an die zweite Interdigitalwandler-Elektrode (803) angrenzend enthalten,
die jeweiligen primären Anregungsbereiche (806, 808) der ersten und der zweiten Interdigitalwandler-Elektroden (802, 803) zueinander um das bestimmte Maß entsprechend dem gewünschten Durchlassfrequenzverhalten phasenverschoben sind, und
die erste sowie die zweite Interdigitalwandler-Elektrode an den jeweiligen aneinandergrenzenden Seiten der ersten und der zweiten Interdigitalwandler-Elektrode die jeweiligen sekundären Anregungsbereiche (807, 809) enthalten, die jeweils die von den λ/2-Abständen verschiedenen Elektrodenfinger-Abstände aufweisen.

7. Oberflächenwellenfilter nach Anspruch 1, wobei:
die Vielzahl von Interdigitalwandler-Elektroden (102, 103, 104) eine erste Interdigitalwandler-Elektrode (102) sowie eine zweite und dritte Interdigitalwandler-Elektrode (103, 104) an die jeweiligen Seiten der ersten Interdigitalwandler-Elektrode angrenzend enthält,
die Vielzahl von Reflektorelektroden eine erste und eine zweite Reflektorelektrode
(105, 106) enthält, die an den jeweiligen Außenseiten der drei Interdigitalwandler-Elektroden (102, 103, 104) angeordnet sind,
der primäre Anregungsbereich der ersten Interdigitalwandler-Elektrode (102) gegenüber den jeweiligen primären Anregungsbereichen (107) der zweiten und der dritten Interdigitalwandler-Elektrode (103, 104) um das bestimmte Maß entsprechend dem gewünschten Durchlassfrequenzverhalten phasenverschoben ist, und
die Interdigitalwandler-Elektrode (102, 103, 104) an der Seite derselben, die an eine andere Interdigitalwandler-Elektrode angrenzt, den sekundären Anregungsbereich
(108, 109, 111, 113) enthält, der die von den λ/2-Abständen verschiedenen Elektrodenfinger-Abstände aufweist.

8. Oberflächenwellenfilter nach Anspruch 1, wobei:
die Interdigitalwandler-Elektroden fünf Interdigitalwandler-Elektroden (1002, 1003, 1004, 1005, 1006) enthalten, die nahe beieinander angeordnet sind,
der primäre Anregungsbereich (1011, 1014, 1017, 1020, 1022) der Interdigitalwandler-Elektrode um das bestimmte Maß entsprechend dem gewünschten Durchlassfrequenzverhalten phasenverschoben ist, und
die Interdigitalwandler-Elektrode (1002, 1003, 1004, 1005, 1006) an der Seite derselben, die an eine andere Interdigitalwandler-Elektrode angrenzt, den sekundären Anregungsbereich (1012, 1013, 1015, 1016, 1018, 1019, 1021, 1023) enthält, der die von den λ/2-Abständen verschiedenen Elektrodenfinger-Abstände aufweist.

9. Oberflächenwellenfilter nach einem der Ansprüche 6 bis 8, wobei die Elektrodenfinger-Abstände wenigstens eines der sekundären Anregungsbereiche zwei oder mehr verschiedene Arten von Elektrodenfinger-Abständen enthalten.

10. Oberflächenwellenfilter nach einem der Ansprüche 6 bis 8, wobei die Elektrodenfinger-Abstände wenigstens eines der sekundären Anregungsbereiche schrittweise variieren.

11. Oberflächenwellenfilter nach einem der Ansprüche 6 bis 8, wobei sich die Elektrodenfinger-Abstände wenigstens eines der sekundären Anregungsbereiche voneinander unterscheiden und schrittweise zunehmen.

12. Oberflächenwellenfilter nach einem der Ansprüche 6 bis 8, wobei die Elektrodenfinger-Abstände wenigstens eines der sekundären Anregungsbereiche sämtlich gleich sind.

13. Oberflächenwellenfilter nach einem der Ansprüche 6 bis 8, wobei die Anzahl von Elektrodenfingern aller sekundären Anregungsbereiche wenigstens einer der Interdigitalwandler-Elektroden ein Drittel oder weniger der Gesamtzahl von Elektrodenfingern der Interdigitalwandler-Elektrode ausmacht.

14. Oberflächenwellenfilter nach Anspruch 1, wobei:
die Vielzahl von Interdigitalwandler-Elektroden eine erste und eine zweite Interdigitalwandler-Elektrode (902, 903) enthält,
wenigstens eine der Reflektorelektroden (906) zwischen der ersten und der zweiten Interdigitalwandler-Elektrode (902, 903) angeordnet ist,
die jeweiligen primären Anregungsbereiche der ersten und der zweiten Interdigitalwandler-Elektrode zueinander um das bestimmte Maß entsprechend dem gewünschten Durchlassfrequenzverhalten phasenverschoben sind, und
die Reflektorelektrode (906) von den λ/2-Abständen verschiedene Elektrodenfinger-Abstände aufweist.

15. Oberflächenwellenfilter nach Anspruch 14, wobei die Elektrodenfinger-Abstände der Reflektorelektrode (906) zwei oder mehr verschiedene Arten von Elektrodenfinger-Abständen enthalten.

16. Oberflächenwellenfilter nach Anspruch 14, wobei sich die Elektrodenfinger-Abstände der Reflektorelektrode (906) voneinander unterscheiden und schrittweise zunehmen.

17. Oberflächenwellenfilter nach Anspruch 1, wobei:
die Vielzahl von Interdigitalwandler-Elektroden eine erste, eine zweite und eine dritte Interdigitalwandler-Elektrode (702, 703, 704) enthält,
die Vielzahl von Reflektorelektroden eine erste und eine zweite Reflektorelektrode (707, 708) enthält,
sich die zweite Interdigitalwandler-Elektrode (703) an einer ersten Seite der ersten Interdigitalwandler-Elektrode (702) über die erste Reflektorelektrode (707) befindet,
sich die dritte Interdigitalwandler-Elektrode (704) an einer zweiten Seite der ersten Interdigitalwandler-Elektrode (702) über die zweite Reflektorelektrode (708) befindet,
der primäre Anregungsbereich der ersten Interdigitalwandler-Elektrode (702) gegenüber den jeweiligen primären Anregungsbereichen der zweiten und dritten Interdigitalwandler-Elektrode (703, 704) um das bestimmte Maß entsprechend dem gewünschten Durchlassfrequenzverhalten phasenverschoben ist, und
jede von der ersten und der zweiten Reflektorelektroden (707, 708) von den λ/2-Abständen verschiedene Elektrodenfinger-Abstände aufweist.

18. Oberflächenwellenfilter nach Anspruch 17, wobei die Elektrodenfinger-Abstände wenigstens einer von der ersten und der zweiten Reflektorelektrode (707, 708) zwei oder mehr verschiedene Arten von Elektrodenfinger-Abständen enthalten.

19. Oberflächenwellenfilter nach Anspruch 17, wobei die Elektrodenfinger-Abstände wenigstens einer von der ersten und der zweiten Reflektorelektrode (707, 708) sich voneinander unterscheiden und schrittweise zunehmen.

20. Oberflächenwellenfilter nach Anspruch 1, wobei:
die Vielzahl von Interdigitalwandler-Elektroden wenigstens fünf Interdigitalwandler-Elektroden (1002, 1003, 1004, 1005, 1006) enthält,
die Vielzahl von Reflektorelektroden wenigstens vier Reflektorelektroden enthält, die jeweils zwischen den Interdigitalwandler-Elektroden (1002, 1003, 1004, 1005, 1006) angeordnet sind,
der primäre Anregungsbereich (1011, 1014, 1017, 1020, 1022) der Interdigitalwandler-Elektrode gegenüber dem primären Anregungsbereich einer anderen Interdigitalwandler-Elektrode um das bestimmte Maß entsprechend dem gewünschten Durchlassfrequenzverhalten phasenverschoben ist, und
wenigstens eine der Reflektorelektroden von den λ/2-Abständen verschiedenen Elektrodenfinger-Abstände aufweist.

21. Oberflächenwellenfilter nach Anspruch 20, wobei die Elektrodenfinger-Abstände der Reflektorelektrode zwei oder mehr verschiedene Arten von Elektrodenfinger-Abständen enthalten.

22. Oberflächenwellenfilter nach Anspruch 20, wobei sich die Elektrodenfinger-Abstände der Reflektorelektrode voneinander unterscheiden und schrittweise zunehmen.

## Revendications

1. Filtre à ondes acoustiques de surface à couplage longitudinal comprenant:
un substrat piézoélectrique (101); et
une pluralité d'électrodes de transducteur interdigité (électrodes de IDT) (102, 103, 104) et une pluralité d'électrodes de réflexion (105, 106) disposées sur le substrat piézoélectrique,
où chacune des électrodes de IDT est une électrode interdigitée (102, 103, 104) incluant une pluralité de doigts d'électrodes formant deux modèles en forme de peignes à emboîtement,
où les électrodes de IDT (102, 103, 104) et les électrode de réflexion (105, 106) sont agencées en une relation étroite le long d'une direction de propagation d'une onde acoustique de surface,
où l'électrode de IDT (102, 103, 104) inclut une région d'excitation primaire (107, 110, 112) ayant des pas de doigts d'électrodes de λ/2, ou λ est une longueur d'onde de l'onde acoustique de surface,
où la région d'excitation primaire d'au moins l'une des électrodes de IDT (102, 103, 104) est déphasée par rapport à la région d'excitation primaire d'une autre électrode de IDT par une certaine quantité en conformité avec une réponse de fréquence de bande passante désirée,
**caractérisé en ce que**
chacune de l'une des électrodes de IDT (102, 103, 104) et une autre électrode parmi les électrodes de IDT (102, 103, 104) disposées adjacentes entre elles inclut une région d'excitation secondaire (108, 109, 111, 113) ayant des pas de doigts d'électrodes différents des pas de λ/2, sur des côtés correspondants adjacents entre eux, où la région d'excitation secondaire est une partie de ladite chacune de ladite l'une parmi les électrodes de IDT et ladite une autre électrode parmi les électrodes de IDT chacune formant les deux modèles en forme de peignes à emboîtement, et/ou
l'électrode de réflexion ayant deux ou plusieurs types différents de pas de doigts d'électrodes différents des pas de λ/2 est disposée entre les électrodes de IDT disposées adjacentes entre elles.

2. Filtre à ondes acoustiques de surface selon la revendication 1, dans lequel tous les pas de doigts d'électrodes du filtre à ondes acoustiques de surface se trouvent dans une gamme de 0,8λ/2 à 1,2λ/2.

3. Filtre à ondes acoustiques de surface selon la revendication 1, dans lequel l'onde acoustique de surface est une onde acoustique de surface de fuite.

4. Filtre à ondes acoustiques de surface selon la revendication 1, dans lequel l'électrode de IDT (1103, 1104) adjacente à une électrode de réflexion la plus à l'extérieur (1105, 1106) des électrodes de réflexion inclut, sur un côté correspondant adjacent à l'électrode de réflexion la plus à l'extérieur, une région d'excitation secondaire (1111, 1113) ayant des pas de doigts d'électrodes différents des pas de λ/2.

5. Filtre à ondes acoustiques de surface selon la revendication 1, dans lequel:
l'électrode de IDT (102, 103, 104) inclut une région d'excitation secondaire (108, 109, 111, 113) ayant des pas de doigts d'électrodes différents des pas de λ/2, et
au moins l'une des électrodes de réflexion (105, 106) a des pas de doigts d'électrodes différents des pas de λ/2.

6. Filtre à ondes acoustiques de surface selon la revendication 1, dans lequel:
la pluralité d'électrodes de IDT (802, 803) inclut une première électrode de IDT (802) et une deuxième électrode de IDT (803) adjacente à la première électrode de IDT (802),
les électrodes de réflexion (804, 805) incluent une première électrode de réflexion (804) adjacente à la première électrode de IDT (802) et une deuxième électrode de réflexion (805) adjacente à la deuxième électrode de IDT (803),
les régions d'excitation primaires respectives (806, 808) des première et deuxième électrodes de IDT (802, 803) sont déphasés entre elles par la certaine quantité en conformité avec la réponse de fréquence de bande passante désirée, et
les première et deuxième électrodes de IDT incluent, sur les côtés adjacents respectifs des première et deuxième électrodes de IDT, les régions d'excitation secondaires respectives (807, 809) chacune ayant les pas de doigts d'électrodes différents des pas de λ/2.

7. Filtre à ondes acoustiques de surface selon la revendication 1, dans lequel:
la pluralité d'électrodes de IDT (102, 103, 104) inclut une première électrode de IDT (102) et des deuxième et troisième électrodes de IDT (103, 104) adjacentes aux côtés respectifs de la première électrode de IDT,
la pluralité d'électrodes de réflexion inclut des première et deuxième électrodes de réflexion (105, 106) disposées sur des côtés externes respectifs des trois électrodes de IDT (102, 103, 104),
la région d'excitation primaire de la première électrode de IDT (102) est déphasée des régions d'excitation primaires respectives (107) des deuxième et troisième électrodes de IDT (103, 104) par la certaine quantité en conformité avec la réponse de fréquence de bande passante désirée, et
l'électrode de IDT (102, 103, 104) inclut, sur le côté correspondant adjacent à une autre électrode de IDT, la région d'excitation secondaire (108, 109, 111, 113) ayant les pas de doigts d'électrodes différents des pas de λ/2.

8. Filtre à ondes acoustiques de surface selon la revendication 1, dans lequel:
les électrodes de IDT incluent cinq électrodes de IDT (1002, 1003, 1004, 1005, 1006) agencées en relation étroite,
la région d'excitation primaire (1011, 1014, 1017, 1020, 1022) de l'électrode de IDT est déphasée par la certaine quantité en conformité avec la réponse de fréquence de bande passante désirée, et
l'électrode de IDT (1002, 1003, 1004, 1005, 1006) inclut, sur le côté correspondant adjacent à une autre électrode de IDT, la région d'excitation secondaire (1012, 1013, 1015, 1016, 1018, 1019, 1021, 1023) ayant les pas de doigts d'électrodes différents des pas de λ/2.

9. Filtre à ondes acoustiques de surface selon lune quelconque des revendications 6 à 8, dans lequel les pas de doigts d'électrodes d'au moins l'une des régions d'excitation secondaires incluent deux ou plusieurs types différents de pas de doigts d'électrodes.

10. Filtre à ondes acoustiques de surface selon lune quelconque des revendications 6 à 8, dans lequel les pas de doigts d'électrodes d'au moins l'une des régions d'excitation secondaires varient graduellement.

11. Filtre à ondes acoustiques de surface selon lune quelconque des revendications 6 à 8, dans lequel les pas de doigts d'électrodes d'au moins l'une des régions d'excitation secondaires sont différents les uns des autres et augmentent graduellement.

12. Filtre à ondes acoustiques de surface selon lune quelconque des revendications 6 à 8, dans lequel les pas de doigts d'électrodes d'au moins l'une des régions d'excitation secondaires sont tous égaux.

13. Filtre à ondes acoustiques de surface selon lune quelconque des revendications 6 à 8, dans lequel le nombre de doigts d'électrodes appartenant tous aux régions d'excitation secondaires d'au moins l'une parmi les électrodes de IDT représente le 1/3 ou moins du nombre total des doigts d'électrodes de l'électrode de IDT.

14. Filtre à ondes acoustiques de surface selon la revendication 1, dans lequel:
la pluralité d'électrodes de IDT inclut des première et deuxième électrodes de IDT (902, 903),
au moins l'une parmi les électrodes de réflexion (906) est disposée entre les première et deuxième électrodes de IDT (902, 903),
les région d'excitation primaires respectives des première et deuxième électrodes de IDT sont déphasées entre elles par la certaine quantité en conformité avec la réponse de fréquence de bande passante désirée, et
l'électrode de réflexion (906) a des pas de doigts d'électrodes différents des pas de λ/2.

15. Filtre à ondes acoustiques de surface selon la revendication 14, dans lequel les pas de doigts d'électrode de l'électrode de réflexion (906) incluent deux ou plusieurs types différents de pas de doigts d'électrode.

16. Filtre à ondes acoustiques de surface selon la revendication 14, dans lequel les pas de doigts d'électrode de l'électrode de réflexion (906) sont différents les uns des autres et augmentent graduellement.

17. Filtre à ondes acoustiques de surface selon la revendication 1, dans lequel:
la pluralité d'électrodes de IDT inclut des première, deuxième et troisième électrodes de IDT (702, 703, 704),
la pluralité d'électrodes de réflexion inclut des première et deuxième électrodes de réflexion (707, 708),
la deuxième électrode de IDT (703) est située sur un premier côté de la première électrode de IDT (702) à travers la première électrode de réflexion (707),
la troisième électrode de IDT (704) est située sur un deuxième côté de la première électrode de IDT (702) à travers la deuxième électrode de réflexion (708),
la région d'excitation primaire de la première électrode de IDT (702) est déphasée des régions d'excitation primaires respectives des deuxième et troisième électrode de IDT (703, 704) par la certaine quantité en conformité avec la réponse de fréquence de bande passante désirée, et
chacune des première et deuxième électrodes de réflexion (707, 708) a des pas de doigts d'électrodes différents des pas de λ/2.

18. Filtre à ondes acoustiques de surface selon la revendication 17, dans lequel les pas de doigts d'électrode d'au moins l'une parmi les première et deuxième électrodes de réflexion (707, 708) incluent deux ou plusieurs types différents de pas de doigts d'électrodes.

19. Filtre à ondes acoustiques de surface selon la revendication 17, dans lequel les pas de doigts d'électrode d'au moins l'une parmi les première et deuxième électrodes de réflexion (707, 708) sont différents les uns des autres et augmentent graduellement.

20. Filtre à ondes acoustiques de surface selon la revendication 1, dans lequel:
la pluralité d'électrodes de IDT inclut au moins cinq électrodes de IDT (1002, 1003, 1004, 1005, 1006),
la pluralité d'électrodes de réflexion inclut au moins quatre électrodes de réflexion chacune disposée entre les électrodes de IDT (1002, 1003, 1004, 1005, 1006),
la région d'excitation primaire (1011, 1014, 1017, 1020, 1022) de l'électrode de IDT est déphasée de la région d'excitation primaire d'une autre électrode de IDT par la certaine quantité en conformité avec la réponse de fréquence de bande passante désirée, et
au moins l'une parmi les électrodes de réflexion a des pas de doigts d'électrode différents des pas de λ/2.

21. Filtre à ondes acoustiques de surface selon la revendication 20, dans lequel les pas de doigts d'électrode de l'électrode de réflexion incluent deux ou plusieurs types différents de pas de doigts d'électrode.

22. Filtre à ondes acoustiques de surface selon la revendication 20, dans lequel les pas de doigts d'électrode de l'électrode de réflexion sont différents les uns des autres et augmentent graduellement.
